# EUROPEAN PATENT APPLICATION

(11) **EP 4 815 642 A1**
(43) Date of publication of application: **30.09.2026**
(21) Application number: 25166550.1
(22) Date of filing: 27.03.2025
(51) Int. Cl.: H05K 1/14, H05K 3/46, H05K 3/36

(54) **COMPONENT CARRIER, METHOD FOR MANUFACTURING A COMPONENT CARRIER AND COMPONENT CARRIER ASSEMBLY**

(71) Applicant: AT & S Austria Technologie & Systemtechnik Aktiengesellschaft, 8700 Leoben-Hinterberg (AT)
(72) Inventor: KRENN, Eva-Maria, 8740 Zeltweg (AT); SCHMID, Gerhard, 8793 Trofaiach (AT)
(74) Representative: Donatello, Daniele

(57) **Abstract**

The present invention relates to a component carrier (100), a method for manufacturing thereof and to a component carrier assembly comprising a component carrier (100), wherein the component carrier (100) comprises a flexible stack (10) and at least two further stacks (20, 30, 40), wherein a first further stack (30) and the second further stack (40) each are electrically connected to the flexible stack (10) by an electrical connection (33, 43) comprising electrically conductive paste, wherein each of said stacks (10, 20, 30, 40) comprises a stacking direction (Z1, Z2, Z3, Z4) and at least one lateral surface (14, 15; 24, 25; 34, 35; 44, 45) limiting the extension of said stack (10, 20, 30, 40) in planar direction (P) perpendicular to its stacking direction (Z1, Z2, Z3, Z4), wherein at least one lateral surface (14, 15) of the flexible stack (10) and at least one lateral surface (34, 35; 44, 45) of one of the at least two further stacks (30, 40), each facing towards a same lateral side of the component carrier (100, 200, 300, 400, 500, 600, 700, 800), are extending in different spatial planes.

## Description

### FIELD OF THE INVENTION

The present invention generally relates to a component carrier, comprising a flexible stack comprising at least one electrically insulating layer structure and at least one electrically conductive layer structure, wherein the component carrier further comprises at least two further stacks, namely at least a first further stack and a second further stack, each also comprising at least one electrically insulating layer structure and at least one electrically conductive layer structure, wherein each of the first further stack and the second further stack is electrically connected to the flexible stack by an electrical connection comprising electrically conductive paste.

Further, the present invention relates to a method for manufacturing a component carrier as described above.

Additionally, the present invention relates to a component carrier assembly comprising such a component carrier.

### TECHNICAL BACKGROUND

Component carriers as described above, methods for manufacturing them and component carrier assemblies comprising at least one component carrier as described above are generally known.

Also, component carriers combining flexible circuit boards and hard or rigid circuit boards are known. Due to their different mechanical behavior, in general additional measures are required during manufacturing to ensure sufficient and reliable electrical connections.

The known method and also the resulting component carrier have several disadvantages. One disadvantage is, for example, the limited flexibility regarding component carrier build-ups, in particular for build-ups from several sub-assemblies, because precise alignment of the sub-assemblies may be a challenge.

Against this background, the technical problem underlying the present invention is to provide an alternative, in particular improved, component carrier, an alternative, in particular improved, method for producing such a component carrier and an alternative, in particular improved, component carrier assembly, by means of which in particular the known disadvantages can be reduced and which in particular make it possible to provide a component carrier that can be flexibly and very easily adapted to the respective applications and use cases, wherein the component carrier allows in particular to be flexibly adapted to different space requirements and different components and/or parts that are necessary for the respective applications and use cases.

### SUMMARY OF THE INVENTION

With respect to the above, a component carrier, a method for manufacturing a component carrier, and a component carrier assembly comprising a component carrier are provided according to the respective independent patent claims. Advantageous embodiments of the present invention are defined by the dependent patent claims, the description, and the figures. The wording of the claims is hereby made part of the description by express reference.

According to a first aspect of the present invention, a component carrier is provided, wherein the component carrier comprises a flexible stack comprising at least one electrically insulating layer structure and at least one electrically conductive layer structure, and at least two further stacks, namely at least a first further stack and a second further stack, each also comprising at least one electrically insulating layer structure and at least one electrically conductive layer structure. Each of the first further stack and the second further stack is electrically connected to the flexible stack by an electrical connection, in particular by a plurality of electrical connections, comprising electrically conductive paste, wherein each of said stacks comprises a stacking direction and at least one lateral surface limiting the extension of said stack in planar direction perpendicular to its stacking direction. At least one lateral surface of the flexible stack and at least one lateral surface of one of the at least two further stacks, each facing towards a same lateral side of the component carrier, are extending in different spatial planes.

Thereby, in particular by the specific arrangement of the flexible stack relatively to at least one of the further stacks and/or vice versa, the flexibility in manufacturing of the component carrier and also the functionality of a component carrier manufactured resulting in such an arrangement may be increased.

In particular the flexibility in providing different component carriers may be increased. Changes and/or modifications of the design or layout of the component carrier may much easier be realized. As a result, this allows, at least in some cases, to provide component carriers which are more and in particular better adapted to several different applications and/or use cases. Further, scalability and/or a component density may be increased. This may in particular facilitate miniaturization.

Also, compatibility issues between components may be reduced.

As a result, in particular more complex component carrier build-ups or component carrier assemblies may be realized due to increased amount of degrees of freedom. And this in particular in an easy manner and for at least some embodiments without significant additional measures in manufacturing.

Moreover, the potential of the material properties of the flexible stack may be exploited considerably better.

Further, alignment requirements in manufacturing may decrease, resulting in easier and less cost intensive manufacturing. A component carrier according to the first aspect of the present invention enables, for example, in particular because of the flexible stack and the conductive paste, sufficiently and reliably electrically connecting the two further stacks one to each other also when not being perfectly aligned with their spatial planes in the same common plane. The two further stacks may, for example, each be arranged with an inclination to a X-Y plane, to a X-Z plane and/or to a Y-Z plane. Alternatively and/or additionally, they may be arranged with an inclination and/or an offset relative to each other (i.e. not extending in parallel planes). However, the inclination and/or offset must not exceed a defined threshold above which the establishment of reliable electrical connections can no longer be ensured.

In the context of the present application, the term "component carrier" may particularly denote any support structure which is capable of accommodating one or more components thereon and/or therein for providing mechanical support and/or electrical connectivity. A component carrier may also support thermal management, wherein the component carrier may in particular serve as a heat guiding and/or conduction structure, preferably supporting heat dissipation. In other words, a component carrier may be configured as a mechanical and/or electronic and/or thermal (acting) carrier for components.

In particular, a component carrier may be one of or may be configured as a printed circuit board (PCB), an interposer, in particular an organic interposer, and an IC (integrated circuit) substrate. A component carrier may also be a hybrid board combining different ones of the above-mentioned types of component carriers.

In some embodiments, a component carrier may in particular comprise one or more additional stacks and/or more than at least one electrically conductive layer structure per stack and/or one insulating layer structure per stack. A component carrier may, for example, also comprise a solder resist layer structure and/or a protective layer structure. A protective layer structure may also be functionalized as an electrically conductive layer structure for at least one component. Any additional stack may also qualify as a further stack and vice versa.

In at least one embodiment, the component carrier may in particular be a laminate-type component carrier. In such an embodiment, the component carrier may in particular be a compound of multiple layer structures which are stacked one above the other and which are connected together by applying a pressing force and/or heat, in particular with simultaneous application of vacuum.

In the context of the present application, the term "printed circuit board" (PCB) may particularly denote a component carrier, in particular a plate-shaped component carrier, which is preferably formed by at least partially laminating several layer structures, for instance by applying pressure and/or by the supply of thermal energy. A PCB comprises in particular at least one insulating layer structure.

In at least one embodiment, in particular in a preferred embodiment of a PCB, the PCB is in particular formed by at least partially laminating several electrically conductive layer structures with several electrically insulating layer structures. The insulating layer structures may in particular be arranged in between the electrically conductive layer structures, wherein the electrically conductive layer structures and the insulating layer structures may be arranged alternating in stacking direction.

As preferred materials for PCB technology, the electrically conductive layer structures may be made of copper and/or contain at least a certain and defined amount of copper as it is well-known from proper art and usual, whereas the electrically insulating layer structures may comprise resin and/or glass fibers, so-called prepreg or FR4 material. The electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole may either connect the whole stack, (through-hole connections extending through several layers or the entire stack), or the filled hole may connect at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board may in particular be configured for accommodating one or more components on one or both opposing main surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier, in particular an IC substrate. An IC substrate may be, in relation to a PCB, a comparably small component carrier onto which one or more components may be mounted and that may act as a connection medium between one or more chip(s) and a further PCB. For instance, an IC substrate may have substantially the same size as a component (in particular an electronic component) to be mounted thereon (for instance in case of a Chip Scale Package (CSP)). More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections may in particular be arranged within the IC substrate and may be used to provide electrical, thermal and/or mechanical connections of housed components or unhoused components (such as bare dies), particularly of IC chips, with a printed circuit board or intermediate printed circuit board. A "substrate" in the context of the present application in particular facilitates electrical connections and/or dissipating heat and/or offering mechanical strength. Thus, the term "substrate" is in particular used as a synonym of "IC substrate" in the context of the present application. It has to be noted that the term "substrate" may in particular not been mixed up with the term "substrate" as it is usually used in the wafer context in which "substrate" usually means the substrate material used in wafer manufacturing as a base material upon which devices or circuits are built and which forms the foundational layer that supports the electronic or photonic structures integrated into a wafer. This is not what is meant with "substrate" in the context of the present application.

A dielectric part of a substrate (of an IC substrate) may be composed of resin with reinforcing particles (such as reinforcing spheres, in particular glass spheres).

In the context of the present application, the term "interposer" may in particularly denote a physical structure configured to bridge at least one electrical connection. An interposer may in particular be a physical interface layer structure. An interposer may in particular be configured to spread an electrical connection to a wider pitch and/or to bridge between different connection types. An interposer can be made of various materials, including silicon, glass, or organic substrates. An IC substrate or interposer may in particular comprise or consist of an inorganic layer structure or at least a layer of glass, silicon (Si) and/or a photo-imageable or dry-etchable organic material like epoxy-based build-up material (such as epoxy-based build-up film) or polymer compounds (which may or may not include photo- and/or thermosensitive molecules) like polyimide or polybenzoxazole as electrically insulating material.

In the context of the present application, the term "inorganic layer structure" may particularly denote a layer structure which comprises inorganic material, such as an inorganic compound. In particular, dielectric material of the inorganic layer structure or even the entire inorganic layer structure may be made exclusively or at least substantially exclusively from inorganic material. In another embodiment, the inorganic layer structure may comprise inorganic dielectric material and additionally another dielectric material. An inorganic compound may be a chemical compound that lacks carbon-hydrogen bonds or a chemical compound that is not an organic compound. In an example, the inorganic layer structure may comprise glass, for example silicon base glass, in particular solder lime glass, and/or boro-silicate glass and/or alumo-silicate glass and/or lithium silicate glass and/or alkaline free glass. In another example, the inorganic layer structure may comprise ceramic material, for example aluminum nitride and/or aluminum oxide and/or silicon nitride and/or boron nitride and/or sapphire and/or zirconia and/or cordierite and/or cordierite and/or steatite and/or forsterite and/or yttria and/or tungsten comprising ceramic material. Yet, in another example, the inorganic layer structure may comprise semiconducting material, for example silicon and/or germanium and/or silicon oxide and/or germanium oxide and/or silicon carbide and/or gallium nitride. In a further embodiment, the inorganic layer structure may comprise (elemental) metal and/or metal alloys, for example, copper and/or tin and/or bronze. Yet in another embodiment, the inorganic layer structure may comprise inorganic material, which is not listed in the above-mentioned example, such as: MoS2, CuGaO2, AgAlO2, LiGaTe2, AgInSe2, CuFeS2, BeO.

In the context of the present application, the term "component" may particularly denote an electronic component which is configured to be mounted on and/or to be embedded into a component carrier, wherein the component may further in particular be configured to be electrically connected to the component carrier. A component can be an inorganic component (such as, for example, a semiconductor component) or a component comprising inorganic material and/or metal material and/or a combination thereof or consisting thereof.

A component may in particular be selected from a group consisting of: an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminum oxide (Al2O3) or aluminum nitride (AIN). In order to increase the heat exchange capacity, other geometries with increased surface area are frequently used as well. Further-more, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga2O3), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, in addition or alternatively, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer, or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In the context of the present application, the term "stack" may particularly denote an arrangement of multiple planar layer structures which are mounted in parallel on top of one another. Some of the layer structures of the stack described herein may be stacked directly onto each other, that means with no further layer structure or component in between or indirectly, wherein between other layer structures described in the present application, further layer structures or components or the like may be arranged which are not described in the present application unless explicitly described to the contrary.

In the context of the present application, the term "flexible stack" may particularly denote a stack which is designed to flex or to be bent without compromising its electrical properties and/or its mechanical properties, making it suitable for use in applications which are subject to mechanical stress, vibration, thermal expansion and/or require complex three-dimensional arrangements of components to be electrically connected one to each other.

Contrary to a "flexible stack", a "rigid stack" may in particular denote a stack which is designed to maintain its shape and structure without substantial flexing or bending during manufacturing and/or use, even when subjected to mechanical stress, vibration, or thermal changes as to be expected during manufacturing and/or use, thereby providing a stable and fixed support of components.

In the context of the present application, the term "electrically conductive layer structure" may particularly denote a layer structure which is electrically conductive. An electrically conductive layer structure may in particular comprise one or more conductive pathways, tracks, and/or signal traces and/or through connections such as vias and holes and/or interconnection structures for interconnection of the layers and/or for connection with other elements and/or components such as bumps, pillars or the like. These electrically conductive structures may for example be etched from copper sheets and may, for example, be laminated onto an electrically non-conductive or electrically insulating layer structure, which in at least one embodiment the component carrier may comprise additionally.

In at least one embodiment, the at least one electrically conductive layer structure of the component carrier comprises at least one of the following group consisting of: copper, aluminum, nickel, silver, gold, palladium, molybdenum, tungsten, and magnesium and/or an alloy comprising at least one material component of the aforementioned group. Although copper is usually preferred, other materials or coated versions thereof are possible as well, in particular coated with supra-conductive material or conductive polymers, such as graphene or poly(3,4-ethylenedioxythiophene) (PEDOT), respectively.

In the context of the present application, the term "electrically insulating layer structure" may denote a layer structure which is electrically non-conductive.

The at least one electrically insulating layer structure may comprise at least one of the following group consisting of: a resin or a polymer, such as epoxy resin, cyanate ester resin, benzocyclobutene resin, bismaleimidetriazine resin, polyphenylene derivate (for example based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres, or other kinds of filler particles, for example made of glass (multilayer glass) in order to form a composite, could be used as well. A semi-cured resin in combination with a reinforcing agent, for example fibers impregnated with the above-mentioned resins, is called prepreg and may also be used. These prepregs are often named after their properties for example FR4 or FR5, which describe their flame-retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating layer structures.

In at least one embodiment of a component carrier according to the present invention, the at least one electrically insulating layer structure may in particular have a dielectric constant (Dk) in a range from 2.0 to 10, preferably in a range from 3.0 to 5.0. The "dielectric constant (Dk)" (or "relative permittivity") indicates a material's ability to store electrical energy in an electric field. It is defined by the ratio of the permittivity of the dielectric material to the permittivity of free space (vacuum). A dielectric is an insulating material, and the dielectric constant (Dk) of an insulator indicates the ability of the insulator to store electric energy in an electrical field. With an electrically insulating layer structure material as proposed, sufficient electrical isolation can be achieved, and the component carrier can be manufactured in a very easy manner.

In at least one embodiment of a component carrier according to the present invention, the at least one electrically insulating layer structure may in particular have a dissipation factor (Df) in a range from 0.001 to 0.05, preferably in a range from 0.02 to 0.03. The "dissipation factor (Df)" indicates the dielectric losses in the material. With an electrically insulating layer structure material as proposed, sufficient electrical isolation can be achieved, and the component carrier can be manufactured in a very easy manner.

In the context of the present application, the term "layer structure" may particularly denote a continuous layer, a patterned layer, or a plurality of non-consecutive islands within a common plane. A layer structure can comprise at least one protruding element such as, for example, one or more solder bumps, copper bumps, pillars, or other bonding structures like these, wherein the at least one protruding element may in particular protrude beyond the surface of a layer structure.

In the context of the present application, in particular with respect to an electrical connection within the component carrier, the term "electrically conductive paste" may particularly denote a specific electrically conductive element, wherein in the context of the present application, the term "electrically conductive element" may particularly denote an element of the component carrier that facilitates the transmission of electrical signals and/or electric current and/or electromagnetic signals, for example high-frequency signals, and which is configured to electrically connect various components and/or layer structures within the component carrier. Electrically conductive elements are, for example, conductive traces, pads and vias.

The term "electrically conductive paste" may in particular denote a type of material that is applied in a paste form and is used to create electrically connections within the component carrier, in particular between at least two electrically conductive layer structures. An electrically conductive paste may comprise electrically conductive particles, such as, for example silver, copper, bismuth, and/or carbon particles and/or a combination thereof, wherein the electrically conductive particles may in particular be suspended in a binder or an adhesive medium. The size of the electrically conductive particles may be in the range of 500 nm to 30 µm. Also, a solder paste and/or sinter paste may be an "electrically conductive paste" in the context of the present application.

The electrically conductive paste may in particular be filled into a small hole or a cavity in the component carrier which is filled with the conductive material for establishing an electrical connection between different layer structures stacked above each other in stacking direction with an insulating layer structure in between. The electrically conductive paste may in particular form a via, preferably a via which establishes an electrical connection in thickness direction or stacking direction between at least two electrically conductive layer structures.

In at least one embodiment of a component carrier according to the present invention, in particular in a preferred embodiment, at least one electrically conductive element may comprise or be made of an electrically conductive paste which is a lead-free paste. The electrically conductive paste may, for example, specifically be designed to fill micro-via structures, thereby creating Z-axis interconnections between several layers in packages and component carriers. Preferably, a first electrically conductive layer structure belonging to a first stack, for example a flexible stack, may be connected by an electrically conductive paste and/or an electrically conductive element to a second electrically conductive layer structure belonging to a second stack. In an example, the second stack may be another flexible stack or a rigid stack. Alternatively, the first stack may be another rigid stack. By the use of such a paste, yield may be increased, and product manufacturing time may be reduced, offering an efficient solution for creating interlayer connections.

In at least one embodiment of a component carrier according to the present invention, in particular in another preferred embodiment, alternatively or additionally at least one cavity may be filled with a screen-printing conductive copper paste for being printed, in particular by thick screen-printing, onto FR4, glass and aluminum substrates.

In at least one embodiment of a component carrier according to the present invention, the conductive paste may be selected dependent on its viscosity, curing/sintering behavior and/or just because of its electrical conductivity properties.

In the context of the present application, the term "cavity" may particularly denote a recess or hollow space having been created within the structure of the component carrier, in particular in between parts and/or components and/or layers of the component carrier.

At least one cavity of the component carrier may have been created at least partially or completely by a mechanical manufacturing step, for instance by drilling and/or milling, in particular by laser drilling and/or mechanical drilling. Additionally or alternatively, an etching process may be used to create at least one cavity of the component carrier at least partially. However, material removal by laser drilling is preferred. This kind of material removal allows very precise and efficient material removal without significant introduction of mechanical stress or other significant unwanted effects into the surrounding material. Further, the resulting surface properties enable the establishment of high-quality electrical connections. In addition, laser material removal allows to handle various materials and a plurality of different cavity sizes in a very easy manner.

In at least one embodiment of a component carrier according to the present invention, the cavity may be filled, in particular completely filled, with electrically conductive paste, wherein said electrically conductive paste may in particular form an electrically conductive element, in particular an electrically conductive element forming an electric connection. Thereby, a very reliable and advantageous electrical connection between the electrically conductive layer structures may be established, in particular an electrical connection which may also significantly contribute to heat dissipation and mechanical strength of the component carrier.

In at least one embodiment of a component carrier according to the present invention, the cavity may have a maximum diameter in a range from 0.03 mm to 1 mm, in particular in a range from 0.05 mm to 0.2 mm. With a cavity size in the proposed range precise electrical contacting can be ensured even with a high contacting density.

In at least one embodiment of a component carrier according to the present invention a cavity filled with electrically conductive paste may in thickness direction at least partially be delimited by two electrically conductive layer structures, wherein preferably a first one of the electrically conductive layer structures may delimit the cavity at its upper side (from above), and wherein a second one of the electrically conductive layer structures may delimit the cavity at its bottom side (from below). Thereby, a very compact and thin component carrier can be provided with precise, reliable, and high-quality electrical interconnections between the at least two electrically conductive layer structures.

In at least one embodiment of a component carrier according to the present invention two electrically conductive layer structures are electrically connected via an electrically conductive element being arranged in between, in particular by electrically conductive paste being provided within a cavity in between. Thereby, a very compact and thin component carrier can be provided with precise, reliable, and high-quality electrical interconnections between the at least two electrically conductive layer structures.

In particular, at least one electrically conductive element may form a so-called ZiC, that means a "Z-interconnection", wherein the abbreviation "ZiC" in particular refers to an electrical interconnection within a stack establishing an electrical connection between two parts of the stack in stacking direction (Z-direction), in particular in vertical direction.

In the context of the present application, the term "stacking direction" or "thickness direction" may particularly refer to a direction perpendicular to a planar extension of at least one layer structure of the stack.

In at least one embodiment of the present invention, at least one body and/or layer structure of the component carrier may comprise a main surface, wherein in the context of the present application, the term "main surface" of a body or a layer structure may particularly denote one of the two largest opposing surfaces of the body or the layer structure or the outermost layer (structure) of the component carriers. The main surfaces may be connected by circumferential side walls, which may also be denoted as "lateral walls" and/or "lateral surfaces". The thickness of a body or a layer structure, such as a stack, may be defined by the distance between the two opposing main surfaces, in particular in direction perpendicular to the extension of the main surface, in particular perpendicular to its planar extension. In at least one possible embodiment, in particular in a preferred embodiment, at least one main surface may extend in a direction perpendicular to the stacking direction of the corresponding stack. In at least one possible embodiment, in particular in a preferred embodiment, in particular alternatively and/or additionally to the main surface's extension perpendicular to the stacking direction, at least one main surface and at least one lateral surface may be aligned with an angle of 90° degrees in between (i.e., perpendicular one to each other).

At least one portion or section of the lateral surface, which may in particular define a "lateral side" of the component carrier (similar to one of the four sides of the lateral wall of a cube, for example) may limit the extension of the stack it is associated to in particular in a planar direction perpendicular to the stacking direction of the associated stack.

In the context of the present application, the term "facing the same lateral side of the component carrier" may in particular denote two lateral sides of the component carrier facing to the same side.

In the context of the present disclosure, the term "spatial plane" may denote a geometric plane that approximates or is representative of the related surface. Specifically, a spatial plane may be determined by mathematical regression, best fit analysis, and/or other appropriate methods or combinations thereof that fit a plane to the overall geometry or contour of the related surface. This definition may include surfaces that are not perfectly planar, including those with curvature, undulations, or irregularities, as long as such the related surface can be reasonably associated with a representative plane derived from its spatial characteristics. A "lateral surface extending in said spatial plane" is understood to extend generally in the direction and orientation defined by the respective spatial plane, while minor deviations, protrusions, or curvatures of the surface relative to the plane may be included within this scope.

In at least one embodiment of the present invention, in particular the at least one lateral surface of the flexible stack may extend in a first spatial plane and the at least one lateral surface of one of the at least two further stacks may extend in a second spatial plane. This allows to provide further advantageous and/or new component carrier configurations. Hence, flexibility and the capability of adaptation to specific use cases and/or applications of the component carrier may increase. The described design may in particular facilitate the realization of changes and/or modifications to the design or layout of the component carrier, in particular without the need of major adjustments to the manufacturing process.

In at least one embodiment of the present invention the first further stack and the second further stack may be configured for providing different functions and/or functionality. The first further stack and the second further stack may, for example, comprise different components differentiating in functionality and/or being configured for different functions. For example, the first further stack may comprise one or more antenna related component(s) to provide an "antenna functionality", whereas the second further stack may, for example, comprise one or microchip(s) and/or memory/ies to provide a "computing, processing and/or storage functionality" or vice versa. In another example, only one of the further stacks may comprise one or more components with a special functionality. For example, only the first further stack may comprise one or more antenna component(s). Or only the second further stack may comprise one or more functional component(s). In yet another example, at least one functional component may be a heat sink and at least one of the further stacks may provide a "heat sink functionality". In yet another embodiment, at least one further stack may comprise one or more IC (integrated circuit), microcontroller, resistor, capacitor, transistor, diode, inductor, sensor and/or die. This may allow, at least in some embodiments, to increase component or function density which may facilitate miniaturization. In some embodiments, this may allow better spatial separation of functionality and/or components. By better spatial separation of functionality and/or components, electromagnetic and/or radio-frequency interference may be reduced what may in particular lead to better signal quality and/or reduced signal transmission errors. Also, the risk of crosstalk may be reduced. Further, this may help to facilitate thermal management. For example, this may allow to arrange hot areas more isolated from sensitive components and minimizing the risk of thermal-related failures. Moreover, separate layers allow more freedom for modification and/or change of individual components or functionalities without affecting the entire component carrier, making it easier to update or upgrade the design.

In a first implementation of the component carrier according to the first aspect of the invention, the at least one lateral surface of the flexible stack may extend in a first spatial plane and the at least one lateral surface of one of the at least two further stacks may extend in a second spatial plane, wherein the first spatial plane and the second spatial plane may in particular extend parallel one to each other.

In at least one embodiment, the first spatial plane and the second spatial plane may be arranged with a distance in between in a direction perpendicular to the respective spatial planes. That means in other words that the first spatial plane and second spatial plane may in particular be arranged with an offset in between, in particular with an offset in a horizontal direction, or in a direction comprising a horizontal directional component and a vertical directional component.

This allows to realize more complex component carrier designs that may in particular offer increased flexibility, may require less space, and/or may help improving thermal management. Said (slightly) distance-offset may further help to ensure that the plurality of electrical connections are as similar as required and therewith having as similar electrical properties as required resulting in very similar or similar behavior. For example, a very similar or the same electrical resistance may help to avoid bypassing of current what may help to optimize performance of the component carrier. The same or almost the same thickness in regard to stacking direction may (also) help to ensure that the respective electrical connection may have a similar, in particular the same or almost the same, physical, mechanical and/or electrical properties/performance as the others of the same plurality of electrical connections.

In at least one embodiment of a component carrier according to the first aspect of the invention, the first spatial plane and the second spatial plane may in particular extend parallel to the stacking direction of the flexible stack and/or to the stacking direction of the at least one further stack the second spatial plane is related to, wherein the second spatial plane may in particular extend parallel to the first spatial plane with an offset to the first spatial plane, i.e. with a distance in between. In other words: The first spatial plane and second spatial plane may in particular be arranged with a distance relatively one to each other, in particular with a distance in horizontal direction in between. They may be arranged on the same vertical level or with also an offset in a vertical direction, or in a direction comprising a vertical directional component and a horizontal directional component.

This also allows to realize more complex component carrier designs, in particular further component carrier designs which may in particular offer increased flexibility, may require less space, and/or may help improving thermal management. The parallel shifting-offset between the first and the second spatial planes may, for example, due to the freedom of the flexible stack and the at least two further stacks to slide one on each other during lamination, help to decrease the internal tensions of the resulted electrical connection. Additionally and/or alternatively the main surfaces and the lateral surfaces of the respective flexible stack and the further stacks may be either aligned by parallel and/or by a 90° angle what may help to ensure an easy, fast and/or efficient manufacturing of the component carrier.

In at least one embodiment of a component carrier according to the first aspect of the invention, the first spatial plane and the second spatial plane may be inclined one to each other, in particular they may be arranged "misaligned" one to each other. The first spatial plane and the second spatial plane may in particular each or one of them being arranged inclined about a horizontal axis and/or a vertical axis. Additionally and/or alternatively, the first spatial plane and the second spatial plane may be twisted relatively one to each other, in particular about each of their center axes and/or about a common axis, in particular about a common center axis when the spatial planes are extending in parallel. The common axis may also be an axis different from a center axis.

In general, all options and/or all possible combinations of orientations of the first spatial plane and the second spatial plane one to each other are possible, so far, they can be realized with the used materials and components in relation to the desired functionality. This may in particular depend on the material properties, in particular on the flexibility, of the flexible stack, and/or on the properties of the conductive paste, and their abilities to compensate any misalignment in order to enable sufficient and reliable electrical connection(s).

Thereby, more complex component carrier designs, in particular further component carrier designs, may be realized, in particular component carrier designs which may in particular offer increased flexibility, may require less space, and/or may help improving thermal management.

In at least one embodiment of a component carrier according to the first aspect of the invention, the first spatial plane and the second spatial plane may extend with different angles, in particular to a horizontal plane or a vertical plane from a front view in a direction perpendicular to the stacking direction.

This may allow to provide component carriers with complex designs, in particular with a component carrier design which may in particular offer increased flexibility, may require less space, and/or may help improving thermal management. Even if the flexible stack and one of the at least two further stacks are not parallel aligned, the electrical connection may ensure a reliable transmission of electric current and/or electric and/or electromagnetic signals.

In at least one embodiment of a component carrier according to the first aspect of the invention, the first spatial plane and the second spatial plane may be inclined one to each other, in particular by at least one defined inclination angle, in particular such they intersect virtually or in reality along a straight line extending parallel to the stacking direction of the flexible stack and/or of the at least one further stack. That means in other words that in at least one embodiment, the first spatial plane and the second spatial plane may extend with different angles from a view parallel to the stacking direction, i.e., from a frontal-top view. The second spatial plane and/or the at least one further stack may in particular be rotated about a vertical axis or an axis parallel to its stacking direction relatively to the first spatial plane. This may in particular result in an arrangement with the at least one further stack being twisted with respect to the flexible stack, in particular with respect to the first spatial plane, about an axis extending parallel to the stacking direction of the further stack. The first spatial plane and the second spatial plane may, for example, be twisted relatively to each other about a vertical axis or z-axis or an axis extending parallel to at least one stacking direction, and/or rotated about different angles about such an axis.

This may allow to provide component carriers with complex designs, in particular with a component carrier design which may in particular offer increased flexibility, may require less space, and/or may help improving thermal management. Due to the physical properties of the flexible stack at least one portion of the stack can be deformed and/or bent. This may bring the advantage of spatially providing the at least one portion into a position after the manufacturing of the component carrier, in particular into a defined and/or desired spatial position. For example, this may include transferring a physical connection function associated to the first further stack to a periphery of the component carrier in order to mechanically connect a wire connector to the component carrier via the before bent first further stack.

In at least one embodiment of a component carrier according to the first aspect of the invention, the first spatial plane and the second spatial plane may be inclined one to each other such they intersect virtually or in reality along a straight line extending in a plane extending perpendicular to the stacking direction of the flexible stack and/or of the at least one further stack. That means in other words that in at least one embodiment, the first spatial plane and the second spatial plane may extend with different angles from a view perpendicular to the stacking direction, i.e., from a side view. The second spatial plane and/or the at least one further stack may in particular be rotated about a horizontal axis or an axis perpendicular to its stacking direction relatively to the first spatial plane. This may in particular result in an arrangement with the at least one further stack being inclined, in particular laterally and/or frontally inclined, with respect to the flexible stack, in particular with respect to the first spatial plane, about an axis extending perpendicular to the stacking direction of the further stack. The first spatial plane and the second spatial plane may, for example, be twisted relatively to each other about a horizontal axis or z-axis or an axis extending perpendicular to at least one stacking direction, and/or rotated about different angles about such an axis.

This may allow to provide component carriers with complex designs, in particular with a component carrier design which may in particular offer increased flexibility, may require less space, and/or may help improving thermal management.

In one embodiment, the first spatial plane and the second spatial plane may, for example, be twisted relatively one to each other about a x-, y, z-, xy-, xz-, xz- or yz-axis and/or rotated about different angles about such an axis.

In one embodiment, in particular in addition, a frontal plane and/or a rear plane of the flexible stack and/or a frontal plane and/or a rear plane of at least one of the further stacks may, for example, be rotated about a x-, y, z-, xy-, xz-, xz- or yz-axis and therewith inclined. This facilitates also providing of a complex component carriers with an advantageous design. Due to the physical properties of the flexible stack at least one portion of the stack can be deformed and/or bent and/or twisted. This may bring the advantage of spatially providing the at least one portion into a position after the manufacturing of the component carrier, in particular into a defined and/or desired spatial position. For example, this may include transferring an antenna function associated to the first further stack to a periphery of the component carrier in order to receive electromagnetic signal provided to the component carrier with less interferences.

In at least one embodiment of a component carrier according to the first aspect of the invention, the first spatial plane of the flexible stack may extend parallel to the stacking direction of the flexible stack.

This orientation of the first spatial plane may have some advantages in some situations. In some situations and/or use cases, this may in particular facilitate manufacturing, in particular stacking. In some situations, it may also allow facilitate to provide component carriers with a high package density.

In at least one embodiment of a component carrier according to the first aspect of the invention, the first spatial plane of the flexible stack may extend inclined to the stacking direction of the flexible stack.

This may allow to provide a component carrier with a complex design, in particular with a component carrier design which may in particular offer increased flexibility, may require less space, and/or may help improving thermal management. This may in some cases also be advantageous with respect to the mechanical behavior of the flexible stack, in particular with respect to the distribution of mechanical stress within the flexible stack.

In at least one embodiment of a component carrier according to the first aspect of the invention, the second spatial plane of the at least one further stack may extend parallel to the stacking direction of said at least one further stack.

This may in some cases be advantageous, for example, if the further stack and/or a component of the further stack requires an exact orientation of the second spatial plane to its stacking direction and/or of its stacking direction, wherein the second spatial plane may facilitate realization of the desired orientation.

In at least one embodiment of a component carrier according to the first aspect of the invention, the second spatial plane of the at least one further stack may extend inclined to the stacking direction of said at least one further stack.

This may allow to provide component carriers with complex designs, in particular with a component carrier design which may in particular offer increased flexibility, may require less space, and/or may help improving thermal management. This may in some cases also be advantageous with respect to the mechanical behavior of the at least one further stack, in particular with respect to the distribution of mechanical stress within the at least one further stack.

In at least one embodiment of a component carrier according to the first aspect of the invention, at an opposite lateral side of the lateral surface of the flexible stack the flexible stack may extend beyond at least one of the further stacks in lateral direction.

This may allow to provide component carriers with complex designs, for example with complex three-dimensional component carrier designs. This may in particular allow providing of component carriers with a design which may in particular offer increased flexibility, may require less space, and/or may help improving thermal management. Such a design of the flexible stack may further facilitate the arrangement and/or electrical connection of a further stack and/or components on the flexible stack.

In at least one embodiment of a component carrier according to the first aspect of the invention, at least one of the two further stacks may be electrically connected to the flexible stack by several, i.e. more than one, electrical connections comprising conductive paste (i.e., not only by a single electrical connection), wherein the electrical connection, in particular the one electrical connection, of said electrical connections in proximity of an edge at which the flexible stack extends laterally beyond said at least further stack is distanced from that edge with a first distance, wherein the electrical connection, in particular the one electrical connection, of said electrical connections in proximity of an edge associated to a lateral side of the at least further stack is distanced from that lateral side with a second distance, wherein said first distance is in particular greater than said second distance, in particular at least two times.

The "edge" is thereby in particular defined by the associated lateral surface of the associated further stack at which the flexible stack extends laterally beyond the further stack.

The "first distance" is the distance between the electrical connection being arranged closest to said edge and said edge, and in a direction perpendicular to the stacking direction and from a planar point of view to the respective edge-lateral side.

The "second distance" is the distance between the electrical connection being arranged remotest to said edge and to the lateral surface opposite to the edge on the same level in stacking direction also from a planar point of view.

By ensuring a sufficient first distance in particular between the one electrical connection being closest to the edge from a planar point of view to the respective edge-lateral side where the flexible stack extends laterally beyond the further stack may allow to provide component carriers with complex designs, for example with complex three-dimensional component carrier designs, in particular designs with a flexible stack being bended in a zone where the flexible stack extends laterally beyond the further stack.

By the first distance, in particular by an appropriate first distance, for example, by a first distance of at least two times of the second distance, negative influence caused by an eventual bending of the flexible stack in the zone where the flexible stack extends laterally beyond said at least further stack may be reduced. In particular negative influence on at least the electrical connection in proximity of the edge, i.e., on the electrical connection being arranged closest or nearest to said edge from which the flexible stack extends laterally beyond, may be reduced.

By a sufficient first distance of the electrical connection which is arranged in proximity, in particular closest to the edge of the lateral side of the at least one further stack where the flexible stack extends beyond said edge or "protrudes" outwards, in particular negative influence caused by bending and resulting in mechanical stress on the electrical connection may be reduced. Thereby, the reliability of at least this electrical connection may be increased, also when the flexible stack is bended in a zone where the flexible stack extends laterally beyond said at least further stack. As a result, component carriers may be provided which allow more bending of the flexible stack while risk of connection failure may be reduced. This enables, as a result, to provide more complex component carrier designs, in particular component carrier designs with increased flexibility, which may require less space, and/or which may help improving thermal management.

In at least one embodiment of a component carrier according to the first aspect of the invention, the first distance may be in a range from 500 µm to 2 mm, wherein the first distance may in particular be at least 500 µm, 600 µm, 700 µm, 800 µm, 900 µm, 1 mm, 1.1 mm, 1.2 mm, 1.3 mm, 1.4 mm, 1.5 mm, 1.6 mm, 1.7 mm, 1.8 mm or 1.9 mm, but in particular less or equal 2 mm, 1.9 mm, 1.8 mm, 1.7 mm, 1.6 mm, 1.6 mm, 1.5 mm, 1.3 mm, 1.2 mm, 1.1 mm, 1.0 mm, 0.9 mm, 0.8 mm, 0.7 mm or 0.6 mm.

With a first distance in the range described above, a negative influence, in particular negative influence caused by bending of the flexible stack on the electrical connection(s), in particular on the electrical connection in proximity to the edge, can be reduced, in particular significantly. In some embodiments completely or almost completely, depending on the bending of the flexible stack and the resulting mechanical stresses with the component carrier. The first distance and/or the second distance may in particular be measured in a cross-section from a cross-section plane extending perpendicular to the edge where the flexible stack extends beyond said edge, wherein the first distance and/or the second distance may in particular be measured from the outmost point the electrical connection in said cross-section to the edge in a direction perpendicular to the stacking direction of the flexible stack or from a center of the area of the respective electrical connection.

In at least one embodiment of a component carrier according to the first aspect of the invention, at least one of the electrical connections, in particular at least one of the electrical connections by which at least one further stack is electrically connected to the flexible stack, in particular at least one of the electrical connections comprising an electrically conductive paste, may comprise a cross-section with a diameter varying along the stacking direction of the respective further stack, wherein the cross-section diameter in particular may increase in direction towards the flexible stack. The electrical connection of the at least one of the two further stacks may also in particular be vertically slanted away from smaller to wider cross section diameter towards the flexible stack.

This may allow to provide component carriers with complex designs, in particular with a component carrier design which may in particular offer increased flexibility, may require less space, and/or may help improving thermal management, and this in particular with reduced risk of failure of the electrical connection. By the larger cross-section diameter in direction towards the flexible stack, more mechanical impact, in particular more lateral movement within the component carrier during manufacturing, in particular before curing of the electrically conductive paste, may be tolerated within the electrical connection without any damage.

In one embodiment, the at least one electrical connection may comprise a cone shaped cross-section or a substantially trapezoidal shaped cross-section. Especially such a shape may result in an advantageous behavior in order to reduce the risk of failure of the electrical connection.

In at least one embodiment of a component carrier according to the first aspect of the invention, at least one of the electrical connections being arranged adjacent, neighboring or near to an edge, at which the flexible stack extends laterally beyond said at least further stack, in particular if the flexible stack comprises at least one bendable region near, adjacent or neighboring to said edge, may comprise a cross-section with a diameter varying along the stacking direction of the respective further stack, wherein the cross-section diameter may in particular increase in direction towards the flexible stack.

Especially such a shape may result in an advantageous behavior in order to reduce the risk of failure of the electrical connection, in particular when the flexible stack is bent. In particular in the context of a bent flexible stack, an improved resistance to connection failure, may allow to provide component carriers with complex designs, in particular with a component carrier design which may in particular offer increased flexibility, may require less space, and/or may help improving thermal management.

In the context of the present invention, the term "near" may in particular denote a design in which a second object characterized as being arranged "near" to a first object is arranged within a defined distance away from the first object. For example, may "near" in particular mean with a distance in a range from 50 µm to 4 mm in 0.05 mm (=50 µm) or 0.1 mm (=100µm) steps.

In at least one embodiment of a component carrier according to the first aspect of the invention, the layers of each of the at least two further stacks may be in parallel one to each other.

This may allow to provide component carriers build-up from conventional sub-stacks as further stacks, but with a complex design component carrier design, in particular with a resulting component carrier design which may in particular offer increased flexibility, may require less space, and/or may help improving thermal management, due to the specific arrangement of the further stacks which can be realized by the flexible stack.

In at least one embodiment of a component carrier according to the first aspect of the invention, at least one further stack may be a rigid stack, in particular all further stacks are rigid stacks.

This may allow to provide build-up component carriers using rigid sub-stacks as further stacks, but with a complex component carrier design, in particular with a resulting component carrier design which may in particular offer increased flexibility, may require less space, and/or may help improving thermal management, due to the specific arrangement of the rigid stacks which can be realized by the flexible stack.

In at least one embodiment of a component carrier according to the first aspect of the invention, at least the two further stacks may be arranged on the same side of the flexible stack, in particular on an upper side or on a bottom side of the flexible stack.

This may facilitate manufacturing, since a 180 degree rotation ("flip") during manufacturing is not required for arranging the at least two further stacks. However, providing of component carriers with an advantageous design, in particular with a component carrier design which may in particular offer increased flexibility, may require less space, and/or may help improving thermal management, is still possible.

In at least one embodiment of a component carrier according to the first aspect of the invention, at least the two further stacks are arranged on opposite sides of the flexible stack, in particular at least one on an upper side and at least one on a bottom side of the flexible stack. This may in some embodiments help to increase the distance between the further stacks and/or help to reduce or avoid an unwanted interaction between these two further stacks. However, providing of component carriers with an advantageous design, in particular with a component carrier design which may in particular offer increased flexibility, may require less space, and/or may help improving thermal management, is still possible.

In at least one embodiment of a component carrier according to the first aspect of the invention, the flexible stack may comprise at least two planar portions, wherein on each one of said at least two planar portions at least one of the two further stacks is arranged.

This may facilitate manufacturing, in particular regarding the establishment of the electrical connections between the flexible stack and the further stacks. However, providing of component carriers with an advantageous design, in particular with a component carrier design which may in particular offer increased flexibility, may require less space, and/or may help improving thermal management, is still possible.

In the context of the present application a "planar portion" may in particular denote a portion, in particular of the flexible stack, which is suitable for mounting components and/or at least one further stack. A "planar portion" may in particular refer to a flat, two-area on the flexible stack that is not folded or bent. In contrast, in a "non-planar portion" the flexible stack may have a curvature and be, for example, bent or folded.

At least one further stack may in particular be arranged with its stacking direction parallel to the stacking direction of the flexible stack in said section with the planar portion, in particular such that the layers of the flexible stack and the layers of the further stack are in parallel.

This may facilitate manufacturing, in particular electrical connecting of the flexible stack and the at least one further stack. However, providing of component carriers with an advantageous design, in particular with a component carrier design which may in particular offer increased flexibility, may require less space, and/or may help improving thermal management, is still possible.

In at least one embodiment of a component carrier according to the first aspect of the invention, the component carrier may comprise at least one additional stack.

This may allow to provide component carriers with a more complex design, in particular with a component carrier design which may in particular offer further increased flexibility, may require less space, and/or may help improving thermal management.

In at least one embodiment, the component carrier may comprise, for example, a flexible stack, a first (further) stack, a second (further) stack, and at least one additional stack, for example a third stack and/or a fourth stack, wherein the first stack, the second stack, the third stack and/or the fourth stack may in particular be rigid stacks.

The more stacks the component carrier comprises, the more functions or functionality may be integrated into the component carrier, in particular if the stacks include different functionality or are configured for different functions.

At least two stacks of the further and/or additional stacks may comprise different functionality and/or different components.

This may allow to provide component carriers with complex designs, in particular with a component carrier design which may in particular offer increased flexibility, may require less space, and/or may help improving thermal management.

In at least one embodiment of a component carrier according to the first aspect of the invention, the additional stack may be arranged on the same side as one of the two further stacks or on the opposite side as one of the two further stacks of the flexible stack, wherein the at least one additional stack may in particular be arranged on the flexible stack or on at least one of the further stacks.

This may allow to provide component carriers with complex designs, in particular with "towers" of sub-stacks. Thereby, component carriers may be provided with a component carrier design which may in particular offer increased flexibility and may comprise high functionality. In particular component carriers may be provided including several different functions or functionality while saving space and/or facilitating thermal management. Additionally or alternatively, the additional stack and one of the at least two further stacks may be connected before the connection to the flexible stack. Thereby, a higher stacking accuracy between the additional stack and the one of the at least two further stacks may be achieved in some cases since there is only one positioning process on the flexible stack needed, which is the most crucial process step for alignment. In an example, the additional stack may be indirectly provided on the flexible stack, in particular, if one of the at least two further stacks is located between the flexible stack and the additional stack.

In at least one embodiment of a component carrier according to the first aspect of the invention, the flexible stack may comprise at least one further planar portion, wherein said at least one additional stack may in particular being arranged on said at least one further planar portion of the flexible stack or on one of the at least two further stacks.

This may allow to provide component carriers with complex but advantageous designs, in particular with a component carrier design which may in particular offer increased flexibility, may be space saving, and/or may help improving thermal management. Additionally or alternatively, this may bring the advantage of mechanically and/or electrically connecting at least two distinct and separated stacks, in particular the additional stack and/or one of the at least two further stacks, via the flexible stack.

In at least one embodiment of a component carrier according to the first aspect of the invention, the flexible stack may comprise at least one bendable portion, in particular a plurality of bendable portions.

This may allow to provide component carriers with complex but advantageous designs, in particular with a component carrier design which may in particular offer increased flexibility, may require less space, and/or may help improving thermal management. This may bring the advantage of imparting bendable and/or elastic properties to the flexible stack and/or the component carrier. This may be beneficial when a portion of the flexible stack and/or the component carrier shall be transformed by a rotation without damaging and/or breaking the component carrier and/or ensuring the electrical integrity after the rotation.

In the context of the present invention, the term "bendable portion" may in particular denote a portion or zone where or in which the flexible stack is deformable, in particular reversibly, in a defined range without being damaged. In "bendable portion" the flexible stack can in particular be bent and/or may have a curved shape or a stretched-bent shape in order to change extension direction of the flexible stack.

In at least one embodiment of a component carrier according to the first aspect of the invention, at least one bendable portion may be arranged between at least two planar portions of the flexible stack in lateral direction of said flexible stack.

This may allow to provide component carriers with complex but advantageous designs, in particular with a component carrier design which may in particular offer increased flexibility, may require less space, and/or may help improving thermal management. Additionally or alternatively, this may help to ensure providing a safe and/or reliable mechanical and/or electrical connection between the at least two planar portions, in particular and especially after bending and/or twisting and/or rotating the bendable portion.

The flexible stack may comprise further planar portions and/or further bendable portions, in particular between said planar portions in lateral direction of said flexible stack. This allows to realize further complex component carrier designs.

In at least one embodiment of a component carrier according to the first aspect of the invention, the additional stack may comprise a lateral surface facing towards the same lateral side of the component carrier extending in a third spatial plane, wherein the third spatial plane may extend in a plane different from the first spatial plane and/or different from the second spatial plane. Preferably, the third spatial plane may be parallel to the first spatial plane and/or the second spatial plane. Additionally or alternatively, the third spatial plane may be inclined to the first spatial plane and/or the second spatial plane. This may indicate that the third spatial plane may be bent and thus may help to ensure providing of a safe and/or reliable mechanical and/or electronic connection between the flexible stack and the additional stack.

This allows to realize further complex component carrier designs.

In at least one embodiment of a component carrier according to the first aspect of the invention, the component carrier may comprise at least one further flexible stack comprising at least one electrically insulating layer structure and at least one electrically conductive layer structure. In at least one possible embodiment, the flexible stack and the at least one further flexible stack may in particular be provided at different spatial locations of the component carrier. This may bring the advantage of providing a component carrier comprising different flexible portions, in particular a component carrier which might be divided into different regions comprising different flexible portions, in particular being divided into different flexible regions by different flexible stacks (one formed by the (first) flexible stack and at least one formed by at least one further flexible stack).

In at least one embodiment of a component carrier according to the first aspect of the invention, the component carrier may further comprise at least one element and/or component.

In some embodiments said at least one element and/or component may in particular be arranged on the flexible stack or on at least one of the further stacks or on at least one of the additional stacks. The at least one element and/or component may in particular be electrically connected to at least one of the stacks of the component carrier, preferably via an electrical connection comprising an electrically conductive paste. Additionally or alternatively, the at least one element and/or component may be connected to at least one of the stacks of the component carrier by a solder connection, in particular by one or more solder balls.

In some embodiments said at least one element and/or component may in particular be arranged in the flexible stack or in any one of the further stacks or in an additional stack. That means in other words, said at least one element and/or component may in particular be integrated or incorporated into one of the stacks.

This may allow to provide component carriers with more complex designs, in particular with a component carrier design which may in particular offer increased flexibility, may require less space, and/or may help improving thermal management.

In at least one embodiment of a component carrier according to the first aspect of the invention, a distance between two neighboring planar portions in lateral direction may be less than the width of at least one further stack. Additionally or alternatively, the distance between two neighboring planar portions in lateral direction may be larger than the width of at least one further stack.

This may allow to provide component carriers with complex but advantageous designs, in particular with a component carrier design which may in particular require less space, and/or may help improving functionality. Such a design may in particular enable an advantageous arrangement of one or more functional components, for example of heat sinks. Additionally or alternatively, this may save space and thus may help to ensure a small and/or compact component carrier.

In at least one embodiment of a component carrier according to the first aspect of the invention, at least between two neighboring planar portions, wherein on each one a further stack is arranged, at least one element or component, in particular a functional component, may be arranged.

This may allow to provide component carriers with complex but advantageous designs, in particular with a component carrier design which may in particular require less space, and/or may help improving functionality. Such a design may in particular enable an advantageous arrangement of one or more functional components. Thus the space of the component carrier may efficiently be used, in particular when the component carrier comprises a complex three dimensional topography and/or shape and/or design.

An "element" or "functional component" may for example be a heat sink, a connector, an interposer, a sensor, a camera, an antenna or the like.

In at least one embodiment of a component carrier according to the first aspect of the invention, the component carrier may comprise one or more sub-assemblies. Each sub-assembly may in particular comprise at least two stacks, in particular at least one flexible stack and/or at least a portion thereof and at least one further stack and/or at least one additional stack, wherein the flexible stack or the portion thereof may in particular be electrically connected to at least one further stack and/or to at least one other stack, for example to an additional stack.

In at least one embodiment of a component carrier according to the first aspect of the invention, the component carrier may comprise one or more sub-assemblies comprising at least two stacks. The at least two stacks may in particular be electrically connected one to each other by at least one electrical connection, in particular by at least one electrical connection comprising electrically conductive paste. Between said electrically connected stacks in particular at least one electrically insulating layer structure may be sandwiched, wherein the insulating layer structure may in particular surround the electrical connection, in particular if the electrical connection is formed by electrically conductive paste.

In at least one embodiment of a component carrier according to the first aspect of the invention, at least one of the electrical connections between said two stacks, in particular at least one of the electrical connections comprising an electrically conductive paste, may (also) comprise a cross-section with a diameter varying along the stacking direction of the respective further stack, wherein the cross-section diameter in particular may increase in direction towards the flexible stack of the component carrier. The electrical connection may also, as already described above, in particular be vertically slanted away from smaller to wider cross section diameter towards the flexible stack.

This may allow to provide component carriers with complex designs, in particular with a component carrier design which may in particular offer increased flexibility, may require less space, and/or may help improving thermal management, and this in particular with reduced risk of failure of the electrical connection. By the larger cross-section diameter in direction towards the flexible stack, more mechanical impact, in particular more lateral movement within the component carrier during manufacturing, in particular before curing of the electrically conductive paste, may be tolerated within the electrical connection without any damage.

In one embodiment, the at least one of such an electrical connection may comprise a cone shaped cross-section or a substantially trapezoidal shaped cross-section. Especially such a shape may result in an advantageous behavior in order to reduce the risk of failure of the electrical connection.

This may allow to provide component carriers with more complex designs, in particular with a component carrier design which may in particular offer increased flexibility, may require less space, and/or may help improving thermal management.

In at least one embodiment, the component carrier may be assembled of sub-assemblies. This may facilitate manufacturing. Further, flexibility may be increased but necessary adaptations of the manufacturing process may be minimized, since in case of an adaptation or amendment mainly the respective sub-assembly and its manufacturing have to be adapted. The component carrier manufacturing process itself, in particular its assembly based on the sub-assemblies may in some embodiments not even require any amendment.

In at least one embodiment, the component carrier may comprise high frequency material, in particular at least one further stack, in particular at least one further stack which is a part of a sub-assembly.

This may allow to adapt the component carrier in an easy manner to different frequencies, in particular by just exchanging the respective stack, in particular the associated sub-assembly. The respective sub-assembly or stack comprising the high frequency material may be adapted to a respective frequency by exchanging or adaption of the high frequency material.

In at least one embodiment of a component carrier according to the first aspect of the invention, the component carrier may comprise a common further stack, wherein said sub-assemblies may be electrically connected to said common further stack, wherein said common further stack may in particular be or comprise the first further stack and/or the second further stack, and/or may in particular be electrically connected to and/or include the first further stack and/or the second further stack.

In some embodiments the common stack may in particular be formed by the first further stack and/or the second further stack. In at least one possible embodiment, the flexible stack may in particular be electrically connected to the common stack, in particular via an electrical connection made of electrically conductive paste, in particular with a cross-section having a diameter increasing in direction towards the flexible stack.

A common further stack may allow to provide a component carrier with a complex but advantageous component carrier design which may in particular offer increased flexibility, may require less space, and/or may help improving thermal management.

In the context of the present application the term "common further stack" may in particular denote a stack with a main surface and to which at least one other stack is connected, wherein a common stack may in particular serve as a "bridge" and/or a coupling stack configured to couple or connect, in particular electrically, at least two other stacks one to each other.

In at least one embodiment of a component carrier according to the first aspect of the invention, at least one layer of one of the several sub-assemblies may be extending in a different layer plane than a corresponding layer or respective layer of the other one of the several sub-assemblies and/or of the common stack (if provided). In at least one embodiment, alternatively at least one layer of one of the several sub-assemblies may be extending in the same layer plane as a corresponding layer or respective layer of the other one of the several sub-assemblies and/or of the common stack (if provided).

This may allow to provide a component carrier with a complex design, in particular with a component carrier design which may in particular offer increased flexibility, may require less space, and/or may help improving thermal management, in particular due to the arrangement of relevant components and/or functionalities in different layer planes.

In the context of the present invention, the term "layer plane" may in particular denote plane in which at least one layer is extending, for example, an electrically conductive layer or an electrically insulating layer.

In at least one possible embodiment of a component carrier according to the first aspect of the invention, a space may be provided between two "neighbored" stacks, in particular between a first stack and a second stack, preferably in a direction perpendicular to the stacking direction of at least one of these "neighbored" stacks, wherein said space may in particular have a planar distance being smaller (or alternatively larger) than a planar width of a third stack, in particular of a third further stack.

In at least one possible embodiment, at least one of these "neighbored" stacks may be part of a sub-assembly.

In at least one possible embodiment, a flexible stack, in particular a flexible stack of one of said sub-assemblies, may comprise at least one bendable portion which may extend outwards from said space to expose from said space, wherein the flexible stack may in particular be stretched-bended in its bendable portion.

In at least one possible embodiment, said third stack may be provided on a flexible stack, in particular on a planar portion of said flexible stack extending adjacent to the bendable, in particular stretched-bended, portion.

In at least one embodiment of a component carrier according to the first aspect of the invention, a space may be provided between a first further stack and a second further stack, wherein the first further stack and the second further stack may in particular be part of different sub-assemblies. Said space may in particular have a planar distance smaller (or alternatively smaller) than a planar width of a third further stack, wherein a flexible stack of one of said sub-assemblies may comprise at least one bendable portion which may extend outwards from said space to expose from said space, wherein the flexible stack may in particular be stretched-bended in its bendable portion.

In at least one further embodiment, the third further stack may in particular be provided on said flexible stack, in particular on a planar portion of said flexible stack extending adjacent to the bendable, in particular stretched-bended, portion.

This may allow to provide a very advantageous component carrier design, in particular a component carrier design which may in particular offer increased flexibility, may require less space, and/or may help improving thermal management. Additionally or alternatively, this may include transferring a physical connection function associated to one of the further stacks to a periphery of the component carrier, in particular by protruding out of the surface, in order to mechanically connect a wire connector to the component carrier.

In a further embodiment, the first and second stacks of the component carrier may be arranged on the same surface, in particular the same main surface of a stack, in particular of a common stack, wherein the first and second stack may in particular be arranged on the same main surface of the flexible stack or of a further stack, in particular of an additional stack.

In at least one embodiment of a component carrier according to the first aspect of the invention, on one sub-assembly of said several sub-assemblies a planar portion of the flexible stack may be arranged, at least partially planarly overlapping at least one stack of said sub-assembly, for example a first further stack and/or a second further stack and/or an additional stack of said one sub-assembly.

This may allow to provide a component carrier with a complex but advantageous design, in particular with a component carrier design which may in particular offer increased flexibility, may require less space, and/or may help improving thermal management. Additionally or alternatively, this may ensure a reliable electrical connection between the flexible stack and one of the other stacks.

In at least one embodiment, at least two layers of the component carrier, in particular at least two layers of different stacks of the component carrier, may have different layer thicknesses. Alternatively or additionally, at least two stacks of a component carrier may have different thicknesses. This may allow to provide a component carrier which enables a flexible packaging, in particular an advantageous integration of different modules while still allowing to provide a component carrier with a high package density. This may in particular allow to provide flexible, adaptive 3D structures comprising high functionality and/or high package density. Thereby, miniaturization may be increased.

In at least one embodiment of a component carrier according to the first aspect of the invention, a second further stack of a sub-assembly, in particular of a further sub-assembly, may be provided on the planar portion being located adjacent to the stretched bended portion of the flexible stack, in particular in addition to a first further stack of another sub-assembly, wherein the second further stack of the further sub-assembly may in particular be arranged on the opposite side of the planar portion of the flexible stack than the first further stack of the other sub-assembly.

This may allow to provide a component carrier with a complex design, in particular with a component carrier design which may in particular offer increased flexibility, may require less space, and/or may help improving thermal management. This may in particular allow to connect further stacks and/or sub-assemblies to the flexible stack, in particular in a space saving and/or spatially advantageous manner. Additionally or alternatively, may this bring the advantage of mechanically and/or electrically connecting the second further stack, especially after bending and/or stretching and/or twisting the stretched bended portion of the flexible stack.

In at least one embodiment of a component carrier according to the first aspect of the invention, on one sub-assembly of said several sub-assemblies a planar portion of the flexible stack may be arranged, at least partially planarly overlapping a first further stack of said further sub-assembly and a second further stack of another sub-assembly. In an example, a first sub-assembly and a second sub-assembly may be provided at the same surface of the flexible stack. In another example, a first sub-assembly and a second sub-assembly may be provided on opposed surfaces of the flexible stack, in particular on the same side or on opposite sides of the planar portion of the flexible stack

This may allow to provide a component carrier with a complex design, in particular with a component carrier design which may in particular offer increased flexibility, may require less space, and/or may help improving thermal management.

In at least one embodiment of a component carrier according to the first aspect of the invention, the planar portion of the flexible stack may be electrically connected, in particular by at least one electrical connection comprising an electrically conductive paste, with at least one further stack of at least one further sub-assembly.

This may allow to provide a component carrier with a complex design, in particular with a component carrier design which may in particular offer increased flexibility, may require less space, and/or may help improving thermal management. For example, a component carrier may be provided comprising two adjacent sub-assemblies, wherein one protruding portion (in particular a protruding portion of the flexible stack) of one sub-assembly is in connection with the other sub-assembly. Additionally or alternatively, connecting the flexible stack with a further stack of a sub-assembly via the planar portion may result in a more reliable mechanical and/or electrical connection, because crack formation between the further stack and the electronic connection and/or between the flexible stack and the electrical connection may be reduced since there will likely no force be applied, for example shearing forces, compared to the bendable region of the flexible stack.

In at least one embodiment of a component carrier according to the first aspect of the invention, at least one of the electrical connections, in particular at least one of the electrical connections by which the planar portion of the flexible stack is electrically connected to at least one further stack, in particular at least one of the electrical connections comprising an electrically conductive paste, may comprise a cross-section with a diameter varying along the stacking direction of the respective further stack, wherein the cross-section diameter in particular may increase in direction towards the flexible stack. The electrical connection of the at least one of the two further stacks may also in particular be vertically slanted away from smaller to wider cross section diameter towards the flexible stack.

This may allow to provide component carriers with complex designs, in particular with a component carrier design which may in particular offer increased flexibility, may require less space, and/or may help improving thermal management, and this in particular with reduced risk of failure of the electrical connection. By the larger cross-section diameter in direction towards the flexible stack, more mechanical impact, in particular more lateral movement within the component carrier during manufacturing, in particular before curing of the electrically conductive paste, may be tolerated within the electrical connection without any damage.

In one embodiment, the at least one electrical connection may comprise a cone shaped cross-section or a substantially trapezoidal shaped cross-section. Especially such a shape may result in an advantageous behavior in order to reduce the risk of failure of the electrical connection.

In at least one embodiment of a component carrier according to the first aspect of the invention, the common further stack may be configured to connect signal/power/GND functions with the at least two further stacks, in particular further stacks each belonging to a respective sub-assembly.

This may allow to provide a component carrier with a complex design, wherein the at least two further stacks may be electrically connected via the common further stack.

In at least one embodiment of a component carrier according to the first aspect of the invention, the flexible stack may be configured to connect signal/power/GND functions with the at least two further stacks.

This may allow to provide component carriers with complex designs, in particular with a component carrier design which may in particular offer increased flexibility, may require less space, and/or may help improving thermal management and/or may allow to provide a component carrier with a high functionality and/or a high package density.

A method for manufacturing a component carrier according to the second aspect of the present invention comprises at least the following steps:
- providing a flexible stack comprising at least one electrically insulating layer structure and at least one electrically conductive layer structure,
- providing at least two further stacks, namely at least a first further stack and a second further stack, each also comprising at least one electrically insulating layer structure and at least one electrically conductive layer structure, and
- electrically connecting said at least two further stacks by establishing an electrical connection comprising electrically conductive paste such that each of the first further stack and the second further stack is finally electrically connected to the flexible stack.

Each of said stacks comprises a stacking direction and at least one lateral surface limiting the extension of said stack in planar direction perpendicular to its stacking direction, wherein the flexible stack and the at least two further stacks are arranged based on the orientation of their lateral surfaces relatively to each other such that at least one lateral surface of the flexible stack and at least one lateral surface of one of the at least two further stacks, each facing towards a same lateral side of the component carrier, are extending in different spatial planes.

With a method according to the second aspect of the present invention, a component carrier with the advantages of a component carrier according to the first aspect of the present invention as described above in detail may be provided. In particular, a component carrier with a complex design may be provided, in particular a component carrier with a design which may in particular offer increased flexibility, may require less space, and/or may help improving thermal management.

A component carrier assembly according to the third aspect of the present invention, comprises a component carrier according to the first aspect of the present invention and/or a component carrier manufactured using a method according to the second aspect of the present invention and at least one further part.

The preferred embodiments presented with reference to a component carrier according to the first aspect of the present invention and its advantages apply correspondingly to a method according to the second aspect of the present invention, and to a component carrier assembly according to the third aspect of the present invention as well and vice versa.

Further features of the invention are shown in the claims, the figures, and the description of the figures. All the features and combinations of features mentioned above in the description as well as the features and combinations of features mentioned below in the description of the figures and/or shown alone or in combination in the figures can be used not only in the combination as indicated or shown in each case, but also in other combinations or on their own so far it can technically be realized.

### SHORT DESCRIPTION OF THE DRAWINGS

The aspects of the present invention defined above, and further aspects of the invention are apparent from the examples, will now be explained in more detail by way of preferred examples and with reference to the accompanying, but not limiting, drawings. The accompanying drawings merely present some embodiments of the present invention. Modifications to these embodiments are possible without departing from the scope of the present invention as defined in the claims. Functionally identical components are provided with the same reference signs for ease of understanding, in particular for simplified recognition, even if they are or may be designed differently, whereby differences may lie in particular in the dimensions, geometry and/or shape as well as in the material and/or their location within the component carrier.

The drawings show:
- **Fig. 1:**: in a frontal view (i.e., in a side view from the front) a cross-section of a first embodiment of a component carrier according to the present invention,
- **Fig. 2:**: in a frontal view (i.e., in a side view from the front) a cross-section of a second embodiment of a component carrier according to the present invention,
- **Fig. 3:**: in a frontal view (i.e., in a side view from the front) a cross-section of a further embodiment of a component carrier according to the present invention,
- **Fig. 4:**: in a frontal view (i.e., in a side view from the front) a cross-section of a further embodiment of a component carrier according to the present invention,
- **Fig. 5:**: in a frontal view (i.e., in a side view from the front) a cross-section of a further embodiment of a component carrier according to the present invention,
- **Fig. 6:**: in a plan view (i.e. in view from the top) a schematic illustration of a possible arrangement of a further stack relatively to a flexible stack,
- **Fig. 7:**: in a plan view (i.e. in view from the top) a schematic illustration of a further embodiment of a component carrier according to the present invention,
- **Fig. 8:**: in a plan view (i.e. in view from the top) a schematic illustration of a further embodiment of a component carrier according to the present invention,
- **Fig. 9:**: in a frontal view (i.e., in a side view from the front) an illustration of a cross-section of a possible arrangement of a further stack relatively to a flexible stack,
- **Fig. 10:**: in a frontal view (i.e., in a side view from the front) an illustration of a cross-section of a possible arrangement of a further stack relatively to a flexible stack,
- **Fig. 11:**: in a frontal view (i.e., in a side view from the front) an illustration of a cross-section of a possible arrangement of a further stack relatively to a flexible stack,
- **Fig. 12:**: in a frontal view (i.e., in a side view from the front) an illustration of a cross-section of a possible arrangement of a further stack relatively to a flexible stack,
- **Fig. 13:**: in a plan view (i.e., in view from the top) a schematic illustration of a possible arrangement of a further stack relatively to a flexible stack,
- **Fig. 14:**: in a plan view (i.e., in view from the top) a schematic illustration of a possible arrangement of a further stack relatively to a flexible stack,
- **Fig. 15:**: in a plan view (i.e., in view from the top) a schematic illustration of a possible arrangement of a further stack relatively to a flexible stack,
- **Fig. 16:**: in a plan view (i.e., in view from the top) a schematic illustration of a possible arrangement of a further stack relatively to a flexible stack,
- **Fig. 17:**: a perspective view of a schematic three-dimensional illustration of a possible arrangement of a further stack relatively to a flexible stack,
- **Fig. 18:**: a perspective view of a schematic three-dimensional illustration of a possible arrangement of a further stack relatively to a flexible stack,
- **Fig. 19:**: a perspective view of a schematic three-dimensional illustration of a possible arrangement of a further stack relatively to a flexible stack,
- **Fig. 20:**: in a frontal view (i.e., in a side view from the front) a cross-section of a further embodiment of a component carrier according to the present invention, and
- **Fig. 21:**: a flow chart of an embodiment of a method according to the present invention.

### DETAILED DESCRIPTION

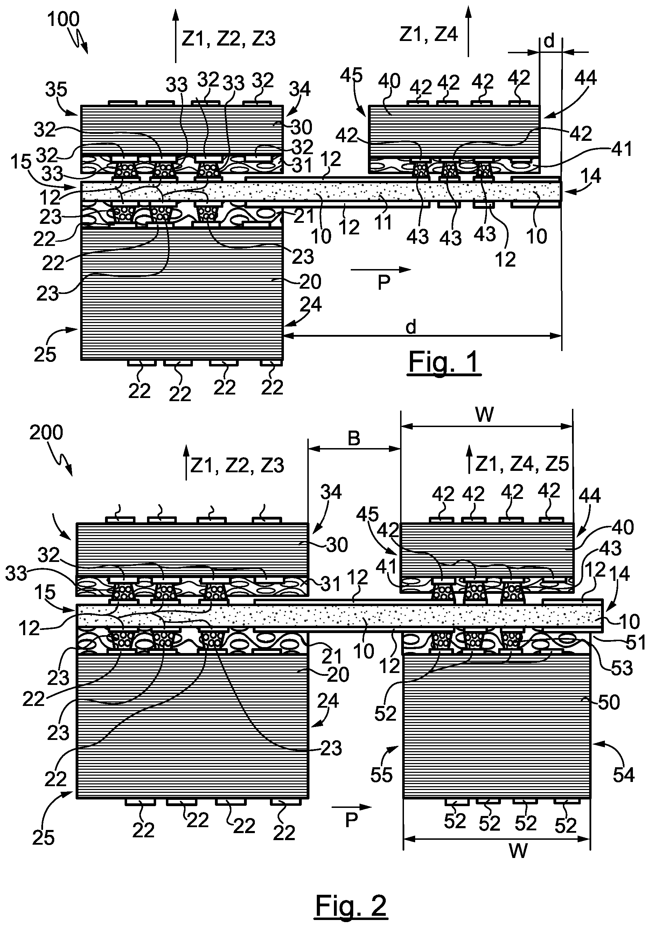

**Fig. 1** shows in a frontal view (i.e., in a side view from the front) a cross-section of a first embodiment of a component carrier 100 according to the present invention, wherein said component carrier 100 comprises a flexible stack 10, a first further stack 20, a second further stack 30 and a third further stack 40. Each of said stacks 10, 20, 30, 40 of the component carrier 100 comprises a stacking direction Z1, Z2, Z3, Z4, respectively, wherein stacking direction Z1 is associated to the flexible stack 10, stacking direction Z2 is associated to the further stack 20, stacking direction Z3 is associated to stack 30, and stacking direction Z4 is associated to stack 40.

The flexible stack 10 comprises an electrically insulating layer structure 11 inside and two electrically conductive layer structures 12. The flexible stack 10 further comprises another electrically conductive layer structure inside (not shown). Alternatively, the flexible stack 10 may comprise only one layer structure inside, in particular the electrically insulating layer structure 11 comprising flexible properties, and being arranged, in particular being "sandwiched", between the electrically conductive layer structures 12. In an example, the electrically insulating layer structure 11 may be free from reinforcing fibres. In another example, the flexible material may comprise polyimide.

The flexible stack 10 is a stack 10 which is at least partially or in some sections or portions bendable, in particular reversibly bendable. However, in the embodiment shown in Fig. 1, the flexible stack 10 extends horizontally, in particular perpendicular to its stacking direction Z1. This flexible stack 10 is not bent.

The further stacks 20, 30 and 40 of this exemplary component carrier 100 are rigid printed circuit boards with at least four layers. Each of said further and rigid stacks 20, 30, 40 of this embodiment of a component carrier 100 comprises at least one electrically insulating layer structure and at least one electrically conductive layer structure, wherein in this embodiment each of the further stacks 20, 30, 40 comprises two outer electrically conductive layer structures 22, 32 and 42 and at least one electrically insulating layer structure (not being indicated by a reference sign) in between these electrically conductive layer structures 22, 32, 42 in stacking direction Z2, Z3, Z4 of the respective stack 20, 30, 40. Each of the stacks 20, 30 and 40 of the example of a component carrier 100 shown in Fig. 1 further comprises an electrically insulating layer structure 21, 31, 41 which is also a fiber-reinforced layer structure in the embodiment illustrated in Fig. 1. Preferably, the electrically insulating layer structures 21, 31 and 41 of the further stacks 20, 30, 40 may comprise material being different than the electrically insulating layer structure 21 of the flexible stack 10. In an example, the electrically insulating layer structure 21, 31, 41 of the further stacks 20, 30, 40 may comprise reinforcing material, for example glass fibres. In another example, the electrically insulating layer structure 21, 31, 41 of the further stacks 20, 30, 40 may comprise epoxy resin and/or poly(meth)acrylate.

Each of the further stacks 20, 30 and 40 of the component carrier 100 is electrically connected to the electrically conductive layer structure 12 of the flexible stack 10 via electrical connections 23, 33 and 43, respectively, wherein these electrical connections 23, 33 and 43 each comprise or are made of an electrically conductive paste, wherein the electrically conductive paste has been filled into laser drilled holes in the respective additional electrically insulating layer structures 21, 31 and 41 and been cured.

In the exemplary embodiment of a component carrier 100 shown in Fig. 1, all the layers of each of the further stacks 20, 30 and 40 are extending parallel one to each other in a planar direction P and in a direction perpendicular to the respective stacking directions Z2, Z3, Z4 of the stacks 20, 30, 40. The planar direction P is indicated by the arrow named with P.

In this embodiment of a component carrier 100 according to the first aspect of the present invention, the layers of each of the further stacks 20, 30 and 40 are further extending parallel to the layers of the flexible stack 10.

The further stacks 20 and 30 are arranged on opposite sides of the flexible stack 10, wherein the further stacks 30 and 40 are arranged on the same side of the flexible stack 10, wherein in this exemplary embodiment of a component carrier 100 the further stacks 30 and 40 are both arranged on the upper side of the flexible stack 10.

The flexible stack 10 comprises a planar upper surface and a planar bottom surface with a first planar portion on its upper left side onto which the further stack 30 is arranged, and with a second planar portion on its bottom left side, where the further stack 20 is attached to, and with a third planar portion on its upper right side onto which the further stack 40 is arranged.

Further, each of said stacks 10, 20, 30 and 40 comprises two lateral surfaces, in particular a left one and a right one, wherein in this embodiment in Fig. 1 the left lateral surface of the flexible stack 10 is indicated with reference sign 15, the left lateral surface of stack 20 with reference sign 25, the left lateral surface of the stack 30 with reference sign 35 and the left lateral surface of the stack 40 with reference sign 45, wherein the indication of "left" is related to the illustration in Fig. 1.

The right lateral surface of the flexible stack 10 is indicated by reference sign 14, the right lateral surface of stack 20 by reference sign 24, the right lateral surface of stack 30 by reference sign 34 and the right lateral surface of stack 40 by reference sign 44. Each of the lateral surfaces 14, 24, 34 and 44 limits the extension of the respective stack 10, 20, 30, 40 in planar direction P and perpendicular to its stacking direction to the right, and each of the lateral surfaces 15, 25, 35 and 45 limits the extension of the corresponding stack in planar direction P and perpendicular to its stacking direction to the left.

In this embodiment of a component carrier 100 according to the first aspect of the present invention, the left lateral surface 15 of the flexible stack 10 and the left lateral surface 25, 35 and 45 of the further stacks 20, 30 and 40 are each facing towards a same lateral side of the component carrier 100, namely to the left side.

Also, the right lateral surface 14 of the flexible stack 10 and the right lateral surfaces 24, 34 and 44 of the further stacks are each facing towards a same side, however namely to the right side.

Therein, the right lateral surface 14 of the flexible stack 10 is extending in a different spatial plane than the right lateral surfaces of the further stacks 20, 30 and 40.

The left lateral surface of 45 of stack 40 is also extending in a different spatial plane than the left lateral surface 15 of the flexible stack 10, although the left lateral surface 15 of the flexible stack 10 and the left lateral surface of 45 of stack 40 are each facing towards the same side, namely the left side.

The right lateral surface 14 of the flexible stack 10 is in particular extending in a first spatial plane, wherein the lateral surfaces 24, 34 and 44 of the further stacks 20, 30 and 40 are extending in different spatial planes. The lateral surfaces 24 and 34 of the stacks 20 and 30 of the component carrier 100 shown in Fig. 1 are in particular extending in a second spatial plane, whilst the right lateral surface 44 of the stack 40 is extending in a third spatial plane. In an alternative embodiment, the lateral surfaces 24 and 34 of the stacks 20 and 30 may alternatively extend in different spatial planes, i.e., in spatial planes being different from each other.

The right lateral surface 14 of the flexible stack 10 extends is in this embodiment of a component carrier 100 parallel to the other right lateral surfaces 24, 34 and 44 of the further stacks 20, 30 and 40, however with a distance d in between in a direction perpendicular to the respective spatial planes, here in particular with a distance d in planar direction P, wherein the distance d is in Fig. 1 exemplarily indicated between the spatial plane of lateral surface 14 and the spatial plane of lateral surface 44, and also between the spatial plane of lateral surface 14 and the respective spatial plane of lateral surface 24. In another embodiment, in particular the distance d between the spatial plane of lateral surface 14 and the spatial plane of lateral surface 44 may be d = 0 mm.

In the embodiment shown in Fig. 1, the spatial plane defined by lateral surface 14 and, for example, the spatial plane defined by lateral surface 44 of the further stack 40, are extending in parallel in stacking direction Z1 of the flexible stack 10, and as well in parallel to the stacking direction Z4 of the further stack 40.

In this component carrier 100, also the spatial planes defined by the lateral surfaces 24 and 34 are extending in parallel to the spatial plane defined by lateral surface 14, wherein the spatial planes defined by lateral surfaces 24 and 34 are also extending in parallel to the stacking direction Z1 of the flexible stack 10. The spatial planes defined by lateral surfaces 24 and 34 are as well extending in parallel to the stacking direction Z2 of the further stack 20 and in parallel to the stacking direction Z3 of the further stack 30.

What is more in this exemplary embodiment of a component carrier 100 is that all lateral surfaces 14, 15; 24, 25; 34, 35; 44, 45 are extending in parallel to the respective stacking direction Z1, Z2, Z3, Z4 of the stack they are associated to, wherein the lateral surfaces 15, 25 and 35 are extending in the same plane. Also, the lateral surfaces 24 and 34 are extending in the same spatial plane. In an alternative embodiment, the lateral surfaces 15, 25 and/or 35 may also extend in different spatial planes. The same applies mutatis mutandis to the lateral surfaces 24 and 34: they may also extend in different spatial planes.

In the embodiment of the component carrier 100 according to the first aspect of the present invention exemplarily shown in Fig. 1, at an opposite side of the left lateral surface 15, the flexible stack 10 extends beyond the further stacks 20 and 30, in particular beyond an edge and/or beyond the right lateral surfaces 24 and 34, wherein in the embodiment shown in Fig. 1, the flexible stack 10 extends beyond the further stacks 20 and 30 to the right. This allows to provide complex and advantageous component carrier configurations and designs.

In this embodiment, at the opposite side of the lateral surface 14 of the flexible stack 10, the flexible stack 10 also extends beyond an edge and/or beyond the lateral surface 45 of the further stack 40, wherein with respect to the further stack 40 the flexible stack 10 extends beyond the lateral surface 45 of the further stack 40 to the left. This also enables the provision of complex and advantageous component carrier configurations and designs.

The electrical connections 23, 33 and 43 of the component carrier 100, which comprise electrically conductive paste, each one of the electrical connections 23, 33, 43 comprises a cross-section with a diameter varying along the respective stacking directions Z2, Z3, Z4 of the respective further stacks 20, 30, 40, wherein the diameter of the electrical connections 33 and 43 each increases in direction towards the flexible stack 10. This may have some advantages, in particular if the flexible stack 10 is bent resulting in a convex shape with an outer surface facing towards the further stacks 30 and 40.

To the contrary, in this embodiment of a component carrier 100, the electrical connections 23 between the further stack 20 and flexible stack 10 have a cross-section with a diameter decreasing in direction towards the flexible stack 10. This is also a possible configuration. However, in some embodiments it might be more advantageous if the diameter of the cross-sections also increases in direction towards the flexible stack 10. An increasing diameter of the cross-section of an electrical connection, in particular increasing in a direction towards the flexible stack 10, may in particular be advantageous for electrical connections being arranged adjacent, neighboring, or near to an edge, at which the flexible stack 10 extends beyond said edge.

Electrical connections 23 serve in particular for establishing an electrical connection between the electrically conductive layer structures 12 and 22 of the flexible stack and the further stack 20. Stacks 30 and 40 are in particular electrically connected with the flexible stack 10 via electrical connections 33 and 43 and the electrically conductive layer structures 32 and 12 and 42 and 12, respectively.

In this embodiment of a component carrier 100 exemplarily shown in Fig. 1, the stacks 20 and 30 have further the same width and are provided such that the spatial planes 24 and 34 are located/extending in the same virtual plane. The spatial planes 25 and 35 are also located/extending in the same virtual plane, however in a virtual plane being different from that in which spatial planes 24 and 24 are extending.

Furthermore, in this embodiment of a component carrier 100 exemplarily shown in Fig. 1, the further stacks 30 and 40 have the same thickness in stacking direction Z. In another embodiment, they may have different thicknesses. To the contrary, in the embodiment of a component carrier 100 exemplarily shown in Fig. 1, the further stack 20 has a different thickness in stacking direction Z, in particular a different thickness compared to the thickness of further stacks 30 and 40.

The electrically conductive layer structures 12, 22, 32, 42 may comprise a surface finish, for example a finish layer structure comprising or being made by/of gold, ENEPIG or the like.

At least one of the further stacks 20, 30, 40 may comprise one or more embedded component(s).

In at least one area or zone of at least one electrically conductive layer structure 12, 22, 32, 42 of the component carrier 100 shown in Fig. 1, the electrically conductive layer structure 12, 22, 32, 42 is not electrically connected via an electrical connection (element) comprising electrically conductive paste.

The size of the electrical connections 23, 33 and 43, and there with their volume and their amount of electrically conductive paste is nearly the same in the embodiment shown. However, in other embodiments the size, volume, and/or amount of the electrical connection elements, in particular of the electrically conductive paste 23, 33, 43 may be different.

The flexible stack 10 may in particular be a flexible layer structure (a layer structure which may be bent >10 times without damage, in particular without breaking) or a semi-flexible layer structure (a layer structure which may be bent 1 to 10 times without damage, in particular without breaking).

The stacks 20, 30, 40 may be differ from each other, in particular in their build-up, their properties and/or their functionality or may be of same design and/or functionality and/or build-up. In particular at least one stack 20, 30, 40 may be different from the other ones, wherein at least one stack 20, 30, 40 may, for example, be an IC substrate, an interposer, or the like whereas the others may in particular be PCBs (printed circuit boards), and/or may comprise a different material, e.g., a glass core, compared to the others.

**Fig. 2** shows in a frontal view (i.e., in a side view from the front) a cross-section of a second embodiment of a component carrier 200 according to the present invention, wherein this embodiment of a component carrier 200 comprises in addition to the component carrier 100 shown in Fig. 1 an additional stack 50, which is arranged on a further planar portion onto the bottom side of the flexible stack 10. Stack 50 also comprises an electrically insulating layer structure 51 which is also a fiber-reinforced layer structure. The right lateral surface 54 of the further stack 50 extends in a further spatial plane, wherein lateral surfaces 45 and 55 extend in the same spatial plane. This results from a broader width of stack 50 compared to stack 40. Stacks 20 and 30 have the same width in planar direction P, however a width different from the width of stacks 40 and 50. Otherwise, the component carrier 200 is identical to the component carrier 100 shown in Fig. 1.

In an alternative embodiment, lateral surfaces 44 and 54 may extend in the same spatial plane.

The stacks 20, 30, 40 and 50 are arranged such that a distance B between the lateral surfaces 34 and 45 respectively 24 and 55 facing one to each other of the stacks 30 and 40 respectively 20 and 50 is less than a width W of at least one of the further stacks 20, 30 and 40, wherein in Fig. 1 the width W is only exemplarily illustrated for the further stack 40 and the additional stack 50. In this embodiment of a component carrier 200, the width W of the further stack 40 and also the width W of the additional stack 50 are larger than the distance B between the two neighboring portions of the flexible stack 10 which are configured for arrangement of the further stacks 20 and 30 and respectively the further stack 40 and the additional stack 50.

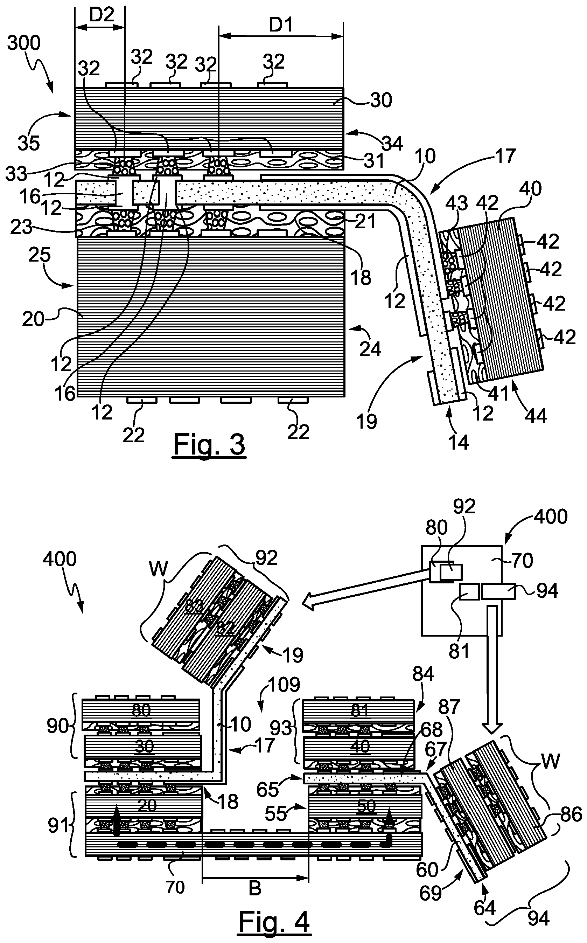

**Fig. 3** shows in a frontal view (i.e., in a side view from the front) a cross-section of a further embodiment of a component carrier 300 according to the present invention, wherein this embodiment of a component carrier 300 is similar to the component carrier 100 shown in Fig. 1, also comprising lateral surfaces, for example the lateral surfaces 14 and 44, extending in different spatial planes while facing towards the same lateral side of the component carrier 300.

Contrary to the component carriers 100 and 200 shown in the previous figures Fig. 1 and Fig. 2, the component carrier 300 shown in Fig. 3 comprises a flexible stack 10 with a portion 17, in which the flexible stack 10 is bent by approximately 85 degrees, wherein said bent portion 17 is located between two planar portions 18 and 19 of the flexible stack 10, wherein in the planar portions 18 and 19 of the flexible stack 10, the further stacks 20, 30 and 40 are attached and electrically connected to the flexible stack 10. In this exemplary embodiment, the bending is such that stack 40 is finally located on the lateral side of the component carrier 300, in particular in a neighboring region to stack 20.

A further difference is that, unlike the other exemplarily shown component carriers 100 and 200 which only comprise electrical connections 23, 33, 43, 53 comprising electrically conductive paste, the component carrier 300 further comprises two vertical interconnections 16 (so-called ZiC - "Z interconnections") for establishing electrical through connections 16 through the flexible stack 10 between the upper electrically conductive layer structure 12 and the bottom electrically conductive layer structure 12 of the flexible stack 10. However, in general the other component carriers described herein, in particular the component carriers 100 and 200 described above, may also comprise one or more vertical ZiC-interconnections 16, at least in another embodiment.

But in accordance with the component carriers 100 and 200 shown in Fig. 1 and Fig. 2 respectively, the component carrier 300 illustrated in Fig. 3 also comprises several electrical connections 23, 33, 43 for electrical connecting each of the further stacks 20, 30 and 40 to the flexible stack 10, wherein the electrical connections 23 and 33 of the several electrical connections 23 and 33, which are arranged remotest from the bent portion 17 of the flexible stack 10, are located with a second distance D2 in planar direction P (i.e., perpendicular to stacking direction, in particular perpendicular to stacking direction Z1 of the flexible stack 10) from the lateral edge of the component carrier 300 which is opposite to the lateral edge where the flexible stack 10 extends beyond the further stacks 20 and 30.

The electrical connections 23 and 33 of the several electrical connections 23 and 33, which are arranged remotest from the bent portion 17 of the flexible stack 10, are in particular located with a second distance D2 from the lateral surface 15 of the flexible stack 10 and/or from the lateral surface 25 of the further stack 20 and/or with a second distance D2 from the lateral surface 35 of the further stack 30.

The electrical connections 23 and 33 of the several electrical connections 23 and 33, which are arranged closest or in proximity to the bent portion 17 of the flexible stack 10, are located with a first distance D1 in planar direction P (i.e., perpendicular to stacking direction, in particular perpendicular to stacking direction Z1 of the flexible stack 10) from the lateral edge of the component carrier 300 at which the flexible stack 10 extends beyond the further stacks 20 and 30.

The electrical connections 23 and 33 of the several electrical connections 23 and 33, which are arranged closest or in proximity to the bent portion 17 of the flexible stack 10, are in particular located with a first distance D1 from the lateral surface 34 the further stack 30.

As shown in Fig. 3 exemplarily for the remotest electrical connection 33, said second distance D2 may in particular extend from the left lateral edge to a center of the remotest electrical connection 33. Said first distance D1, exemplarily shown for the electrical connection 33 being closest to the bent portion 17, may in particular extend from the right lateral edge to a center of the closest electrical connection 33.

The first distance D1 may be larger than the second distance D2, wherein the first distance D1may for example be approximately 2x the second distance D2.

The larger distance D1 may in particular help to reduce or avoid negative influence from the bending in portion 17 of the flexible stack 10 to the electrical connections 33 in proximity of the bent portion 17.

This applies similarly to the electrical connections 23 between the further stack 20 and the flexible stack 10. The first distance D1 may in particular be 100 µm or preferably 200 µm, wherein the second distance D2 may in particular be approximately at least 1 mm, wherein in all of the figures presented in this application, dimensions are not shown scaled, in particular not true to scale, but rather only schematically.

However, in some embodiments, the component carrier may be designed such that the smaller distance is located adjacent to the bent portion 17 and (that one from a closest electrical connection to the bent portion 17), as it is for example the case for the electrical connections 43 between the further stack 40 and the flexible stack 10 as shown in Fig. 3 (the distances are not indicated with any reference signs).

**Fig. 4** shows on the one hand in a frontal view (i.e., in a side view from the front) a cross-section of a further embodiment of a component carrier 400 according to the present invention. In addition, and for a better orientation, in the upper right corner of Fig. 4 a schematic top view of component carrier 400 is illustrated.

This component carrier 400 comprises a more complex design than the component carriers 100, 200 and 300 shown in the Figs. 1 to 3, in particular a complex three-dimensional design which become apparent from the top view in combination with the main view in Fig. 4. This component carrier 400 comprises in particular several additional stacks 80, 81, 82, 83, 86 and 87. The additional stack 86 comprises a high frequency material.

This embodiment of a component carrier 400 comprises a common stack 70 on which two "towers" of stacks are mounted, wherein one of the "towers" is covered by stack 80 and the other by stack 81, wherein each of said top stacks 80 and 81 is part of a separate sub-assembly 90 or 93, respectively, wherein sub-assembly 90 also comprises the further stack 30 and sub-assembly 93 also comprises the further stack 40.

The additional stack 80 is arranged on top of the further stack 30 and electrically connected with stack 30 via electrically connections comprising electrically conductive paste, wherein the corresponding electrical connections between the stacks 80 and 30 are not indicated with reference signs. In the embodiment shown in Fig 4, the width and height of stack 80 is the same as of stack 30. However, in another embodiment, width, and height of the stacks 30 and 80, in particular of the stacks of a sub-assembly, may differ from each other, and also from other stacks and/or sub-assemblies.

The same applies to stacks 40 and 81. The additional stack 81 is arranged on top of the further stack 40 and is electrically connected with this further stack 40 via electrical connections comprising electrically conductive paste, wherein the corresponding electrical connections between the stacks 81 and 40 are also not indicated with reference signs.

Therein, stack 30 is arranged, in particular "sandwiched" between stacks 80 and 10, stack 40 is arranged between stacks 81 and 60.

The stacks 80 and 30 form a sub-assembly 90, and the stacks 81 and 40 form a sub-assembly 93. The stacks 83 and 82 are part of a subassembly 92, and the stacks 86 and 87 are part of a sub-assembly 94. The sub-assemblies 92 and 94 are positioned with different spatial orientation compared to the remaining parts of the component carrier 400, wherein in particular from the top view in the upper right corner of Fig. 4 it is apparent that sub-assembly 92 is located in a zone above the "tower" with stack 80 on top, and partly overlapping the area of top stack 80 without touching stack 80 or the main parts of the associated "tower". Sub-assembly 94 is located in a zone beside the "tower" with stack 81 on top, also without touching said stack 81 or the main parts of the associated "tower".

However, by the corresponding flexible stacks 10, 60 respectively, the sub-assemblies 92 and 94 are each electrically connected to the associated "tower".

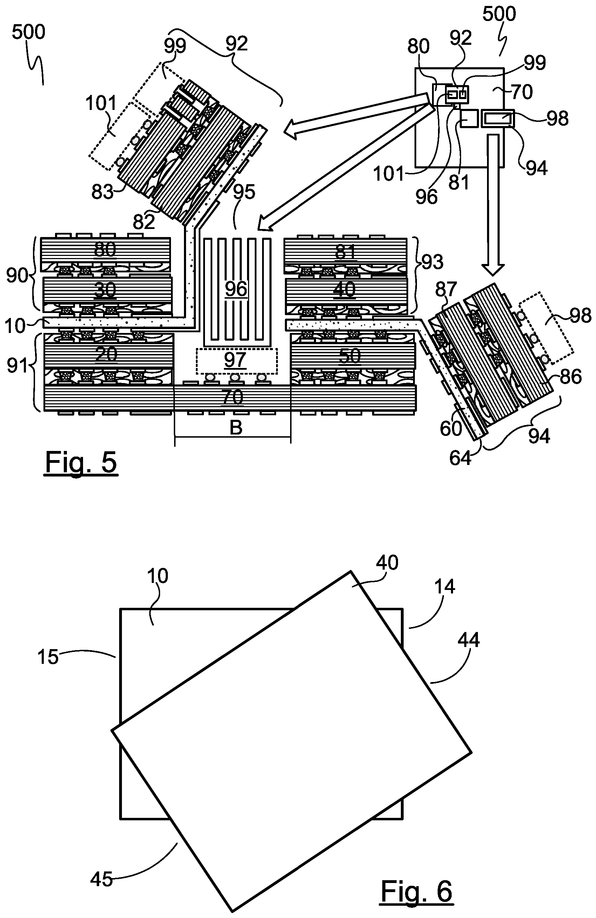

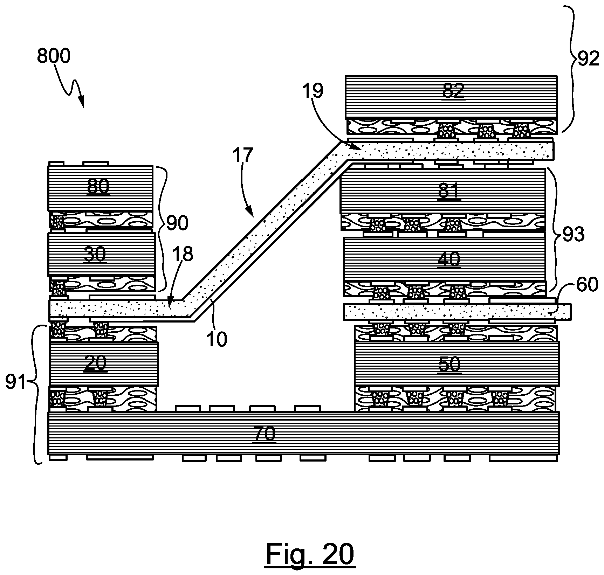

The component carrier 400 further comprises two flexible stacks 10 and 60. Each of the flexible stacks 10 and 60 of component carrier 400 comprises at least two planar portions 18 and 19; 68 and 69, and a bendable portion 17, 67 between the two planar portions 18 and 19; 68 and 69. It has to be noted that in particular in Fig. 4, the bending, in particular the bending angle and/or the bending radius, are not illustrated scaledly. The bending is only illustrated schematically. In particular the bending angle and/or the bending radius are illustrated too sharp. This applies also to Figs. 5 and 20. Preferably, it is much more rounded, as it is for example shown in Fig. 3.

The sub-assembly 90 with its stacks 80 and 30 is arranged in its entirety onto a first planar portion 18 of the flexible stack 10, wherein said first planar portion 18 is arranged between stack 20 and sub-assembly 90, in particular between further stack 20 and further stack 30. Said planar portion 18 is broader in its width than the width stacks 20, 30, 80 and the sub-assembly 90. In another embodiment, the width of the planar portion 18 may be smaller than that one shown in Fig. 4, however preferably not less than the width of the smallest one from the stacks 20, 30, 80.

The sub-assembly 93 with its stacks 81 and 40 is arranged in its entirety onto a first planar portion 68 of the flexible stack 60, wherein said first planar portion 68 is arranged between additional stack 50 and sub-assembly 93, in particular between additional stack 50 and further stack 40.

Sub-assembly 92 and sub-assembly 94 each also comprise a second planar portion 19, 69 of the associated flexible stack 10 respectively 60, to which the sub-assembly 92 respectively sub-assembly 94 are electrically connected. Thus, in this embodiment the two sub-assemblies 92 and 94 each comprise a planar portion 19, 69 of a flexible stack 10 or 60 respectively.

This component carrier 400 also comprises lateral surfaces, for example the lateral surfaces 65 and 55 and/or the lateral surfaces 64 and 84, extending in different spatial planes while facing towards the same lateral side of the component carrier 400.

In another possible embodiment of a component carrier according to the present invention, the component carrier may comprise only one sub-assembly comprising a planar portion of a flexible stack. In another embodiment possible embodiment of a component carrier according to the present invention, all sub-assemblies of the component carrier, i.e., each of all sub-assemblies of the component carrier, may comprise a planar portion of a flexible stack.

The stacks 20 and 50 are in this embodiment part of another sub-assembly 91, in particular of a sub-assembly 91 comprising a common stack 70, wherein stacks 20 and 50 are each arranged on a planar portion of the common stack 70, which is also a rigid stack. Stacks 20 and 50 are also electrically connected via electrical connections comprising electrically conductive paste with the rigid common stack 70. Via the common stack 70 at least the stacks 20 and 50 are electrically connected one to each other.

In this embodiment of a component carrier 400, the layers within each sub-assembly 90, 91, 92, 93 and 94, in particular the layers of the respective stacks 80 and 30 (within sub-assembly 90), the layers of the respective stacks 20, 70 and 50 (within sub-assembly 91), the layers of the respective stacks 83 and 82 (within sub-assembly 92), the layers of the respective stacks 81 and 40 (within sub-assembly 93) and the layers of the respective stacks 86 and 87 (within sub-assembly 94) are extending in parallel.

However, the two planar portions 18, 19 and 68, 69 of each of the flexible stacks 10 and 60 are extending in different layer planes and with different spatial orientation one to each other. The flexible stacks 10 and 60, in particular their planar portions 18, 19 and 68, 69, are at least section wise extending with different spatial orientations within the component carrier 400. Thereby, also the sub-assemblies 92 and 94 are arranged with different spatial orientations within the component carrier 400 one to each other and relatively to the remaining sub-assemblies 90, 91 and 93 of the component carrier 400, wherein at least one layer structure of the sub-assembly 92 is extending in a different layer plane than at least one layer structure of the sub-assembly 94.

This allows to provide a component carrier 400 with a space 109 in a planar direction with a planar distance B which is smaller than a width W of one of the stacks 82 or 83 or one of the stacks 86 and 87.

However, the space 109 with the distance B is designed such the flexible stack 10 can extend outwards from said space to expose from said space, wherein the flexible stack 10 comprises a bendable portion 17 in which the flexible stack 10 is stretched-bended to expose from said space 109 between a left group or "tower" of stacks 80, 30 and 20 and a right group or "tower" of stacks 81, 40 and 50.

The stacks 82 and 83 are provided on the flexible stack 10, in particular on a planar portion 19 of said flexible stack 10, which is extending adjacent to the bendable portion 17, in particular adjacent the stretched-bended portion 17. The stretch-bended portion 17 is laterally and/or spatially located between the first planar portion 18 and the second planar portion 19 of the flexible stack 10. Additionally or alternatively, the stretch-bended portion 17 may be laterally located next to the sub-assembly 90, in particular next to the further stack 30 and/or the additional stack 80. Preferably, the stretch-bended portion 19 is free from direct contact with the lateral sides of the sub-assembly 90, in particular free from contact with the lateral surface 34 of the further stack 30.

The stacks 86 and 87 are provided on the flexible stack 60, in particular on a planar portion 69 of said flexible stack 60, which is extending adjacent to the bent portion 67.

The common further stack 70 is configured to connect signal and power and/or GND functions with the stacks 20 and 50 in particular between said stacks 20 and 50. The flexible stack 10 is configured to connect signal and/or power and/or GND functions between stacks 20 and 30 and with stacks 82 and 83, in particular between sub-assemblies 90 and 91 and 92. Flexible stack 60 is configured to connect signal and/or power and/or GND functions between stacks 40, 50 and 87, in particular between sub-assemblies 93, 91 and 94.

**Fig. 5** shows in a frontal view (i.e., in a side view from the front) a cross-section of a further embodiment of a component carrier 500 according to the present invention, wherein the component carrier 500 is similar to a component carrier 400 shown in Fig. 4, but comprises additional components 96, 97, 98, 99 and 101, wherein components 101 and 99 are mounted on top of sub-assembly 92, and wherein component 98 is mounted on top of sub-assembly 98, which is outlined schematically in the top view in the upper right corner of Fig. 5. Also, for a better spatial orientation, in the upper right corner of Fig. 5 a schematic top view of component carrier 500 is illustrated. Apart from this, the component carrier 500 is identical to the component carrier 400 shown in Fig. 4.

The additional components 96 and 97 form a further sub-assembly 95, wherein component 96 is a heat sink and component 97 is a SMT component, that means a component configured for surface mounting via surface mounting technology (SMT). The sub-assembly 95 with the heat sink 96 and the SMT component 97 is arranged in the space 109 between the stacks 80, 30 and 20 on the left and the stacks 81, 40 and 50 on the right (see Fig. 4).

Component 98 is also an SMT component which is arranged on a top side of stack 86 and electrically connected with said stack 86. Component 101 is also a SMT component which is electrically connected to stack 83 onto which top surface it is mounted. Component 99 is a press-fit component electrically connected to stack 83 via a press-fit connection. Components 99 and 101 a part of sub-assembly 92 in the component carrier 500. The additional components 96, 97, 98, 99, 101 may have different functions. Thus, the related sub-assemblies 92, 94, 95 associated to the additional components 96, 97, 98, 99, 101 may be different one to each other in order to ensure a reliable function of the additional components 96, 97, 98, 99, 101. For example, the additional component 98 may be an antenna component, whereas the additional component 101 may be a camera component and the additional component 99 may be a sensor, or the like.

In another embodiment, the common further stack 70 may be directly electrically connected to the flexible stacks 10 and 60, i.e., without the stacks 20 and 50 in between.

**Fig. 6** shows in a plan view (i.e., in view from the top) a schematic illustration of a further possible arrangement of a further stack 40 relatively to a flexible stack 10, wherein this figure illustrates another possible arrangement of a further stack 40 of a component carrier according to the present invention relatively to a flexible stack 10. The further stack 40 may be arranged, as exemplarily shown in Fig. 6, such its lateral surface 44 extending in the second spatial plane extends in stacking direction but not in parallel to the lateral surface 14 defining the first spatial plane of the flexible stack 10. The lateral surface 44 defining the second spatial plane may in particular be arranged inclined or with an angle relatively to the lateral surface 14 defining the first spatial plane, in particular such the first spatial plane and the second spatial plane extend inclined one to each other.

The further stack 40 may in particular be arranged rotated by a defined angle about an axis extending parallel to its stacking direction Z4 (i.e., by a vertical axis extending perpendicular to the drawing plane of Fig. 6).

In general, the flexible stack allows to provide a component carrier wherein each stack and/or sub-assembly may be finally arranged rotated (i.e., with a different spatial orientation) compared to at least one other stack and/or sub-assembly as exemplarily shown in Fig. 6, wherein performing the rotation is in particular only possible before the component carrier is finally cured/laminated. With respect to Fig. 5: For example, stack 80 may finally be arranged rotated about an axis extending parallel to the stacking direction compared to stack 10 and/or 20. Also, sub-assemblies 92 and 94 may be spatially rotated compared to the flexible stack 10, for example. Or stack 81 and/or sub-assembly 93 may be arranged rotated compared to stack 50.

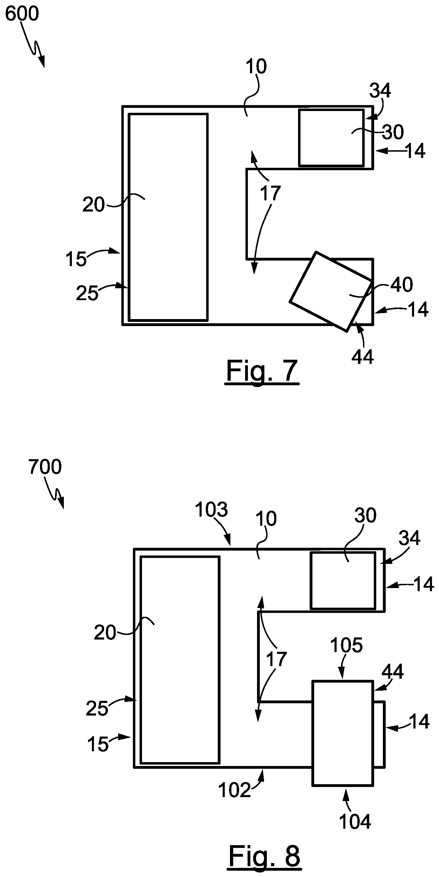

**Fig. 7** shows in a plan view (i.e., in view from the top) a schematic illustration of a further embodiment of a component carrier 600 according to the present invention, wherein in this embodiment the flexible stack 10 has an U-like shape. The first further stack 20 has a rectangular shape, wherein the second further stack 30 has a square shape and the third further stack 40 has also nearly a squared shape. The further stacks 20 and 30 do not extend beyond the borders of the flexible stack 10.

In this embodiment, the further stack 20 is arranged relatively to the flexible stack 10 such that its left lateral surface 25 extends in a spatial plane extending in parallel to the lateral surface 15 respectively in parallel to the corresponding spatial plane of the flexible stack 10.

A portion of the flexible stack 10 which is electrically connected to stack 30 may be bent in a different direction compared to the portion of the flexible stack 10 being electrically connected to stack 40. The different direction may be, for example, in stacking direction, in particular in +Z-direction, or in -Z-direction.

In general, at least two stacks may be arranged one to each other with different spatial orientation, wherein in general all kinds of orientation are possible as long a component carrier with such an orientation can be realized.

Fig. 7 shows one exemplarily embodiment of a component carrier 600 comprising at least two stacks 10 and 40 with different spatial orientation.

The spatial plane 34 respectively the right lateral surface 34 extending in said spatial plane of the further stack 30 is also extending in parallel to the spatial plane of the first lateral surface 14 of the flexible stack 10 on the right side.

However, the further stack 40 is arranged rotated about its stacking direction Z4 relatively to the flexible stack 10 such that the lateral surface 44 of the further stack 40 extends in a spatial plane different from the spatial plane of the flexible stack 10 defined by lateral surface 14, wherein the further stack 40 also extends partially about the borders of the flexible stack 10.

Figs. 8 to 19 show further examples of different spatial orientations of stacks and/or sub-assemblies within a component carrier.

**Fig. 8** shows in a plan view (i.e., in view from the top) a schematic illustration of a further embodiment of a component carrier 700 according to the present invention, wherein in this embodiment the further stack 40 has also a rectangular shape. Its lateral surface 44 extends in parallel to the lateral surface 14 of the flexible stack 10. Thus, the spatial plane in which the lateral surface 14 of the flexible stack 10 extends and the spatial plane in which the lateral surface 44 of the further stack 40 extends, are different ones.

Further, a frontal surface 104 and a rear surface 105 of the further stack 40 are extending in different spatial planes than corresponding front and rear surfaces (not indicated with reference signs) of the flexible stack 10.

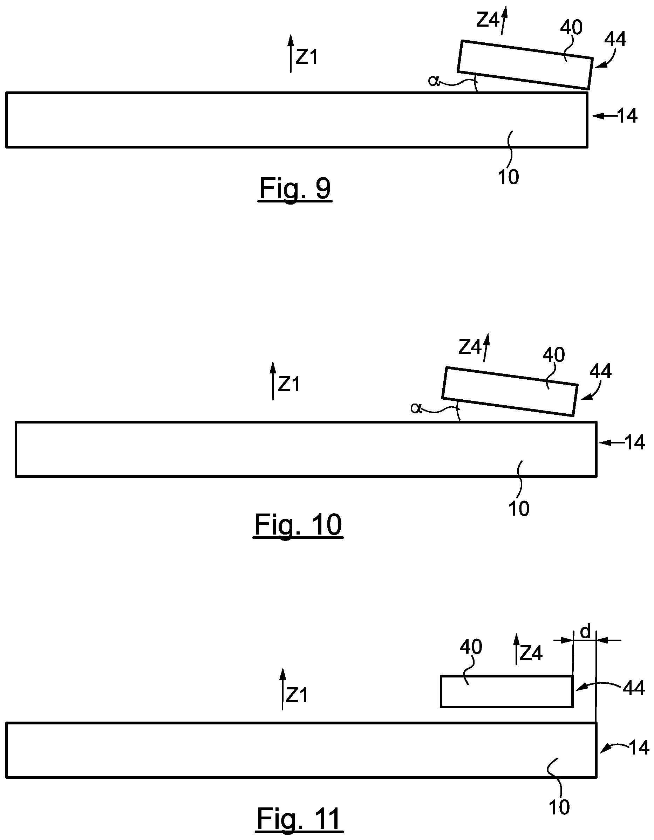

**Fig. 9** shows in a frontal view (i.e., in a side view from the front) an illustration of a cross-section of a further possible arrangement of a further stack 40 relatively to a flexible stack 10, wherein in this arrangement exemplarily shown the further stack 40 is inclined about a horizontal axis extending perpendicular to the drawing plane by an angle α resulting in a stacking direction Z4 not extending parallel to the stacking direction Z1 of the flexible stack 10. However, it has to be noted that stack 40 is electrically connected to the flexible stack 10 via electrical connections, for example via electrical connections 43 as shown in Fig. 1. Stack 40 is not "floating" above the flexible stack 10 even if this appears to be the case in Fig. 9. The illustration in Fig. 9 is also no scaled illustration, but rather a schematic one only. The same applies also for the subsequent figures Fig. 10 to Fig. 12.

**Fig. 10** shows in a frontal view (i.e., in a side view from the front) an illustration of a cross-section of a further possible arrangement of a further stack 40 relatively to a flexible stack 10, wherein in this exemplarily arrangement the further stack 40 is not only inclined about an angle α respectively rotated about a horizontal axis perpendicular to stacking direction Z1, but wherein the further stack 40 is also arranged with an offset to the left in a planar direction perpendicular to stacking direction Z1.

**Fig. 11** shows in a frontal view (i.e., in a side view from the front) an illustration of a cross-section of a further possible arrangement of a further stack 40 relatively to a flexible stack 10, wherein the stack 40 is arranged such that its lateral surface 44 is extending in a different spatial plane from the lateral surface 14 of the flexible stack 10, wherein the lateral surfaces 44 and 14 and therewith also the spatial planes in which they are extending are extending in parallel with a distance d in a planar direction perpendicular to the stacking direction Z1 of the flexible stack 10. The distance d (the offset in lateral direction) may in particular be 100 µm or 200 µm.

In another embodiment, in particular the distance d between the spatial plane of lateral surface 14 and the spatial plane of lateral surface 44 may be d = 0 mm.

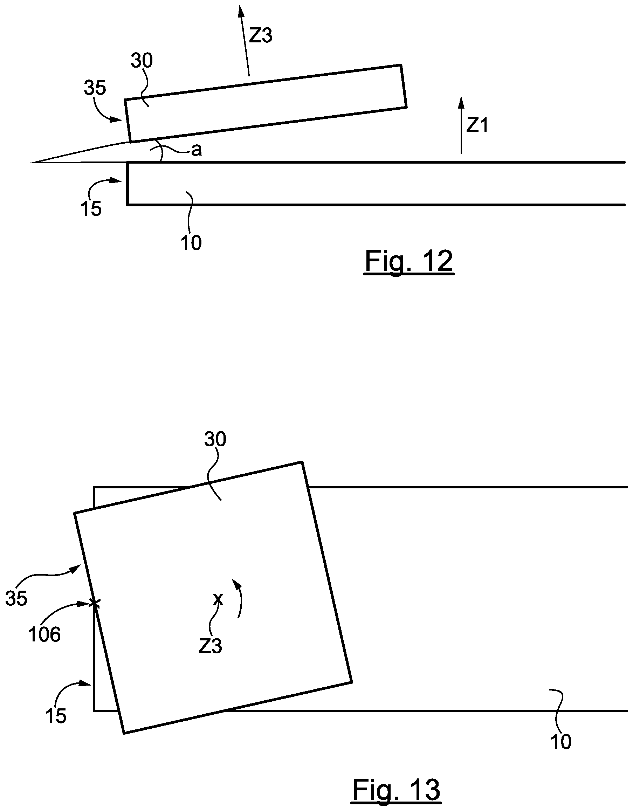

**Fig. 12** shows in a frontal view (i.e., in a side view from the front) an illustration of a cross-section of a further possible arrangement of a further stack 30 relatively to a flexible stack 10, wherein the further stack 30 is arranged with an inclination by angle α about a horizontal axis such that the left lateral surface 35 of said stack 30 extends in a spatial plane with an inclination relatively to the spatial plane in which the lateral surface 15 of the flexible stack extends. Therein, the spatial plane, in which the lateral surface 15 of the flexible stack 10 extends, is extending with a different angle from a view parallel to the stacking direction Z1 than the spatial plane of the lateral surface 35 of the further stack 30. The spatial plane, in which lateral surface 35 of the further stack 30 extends, and the spatial plane 15, in which lateral surface 15 of the flexible stack 10 extends, intersect virtually along a straight horizontal line extending in a plane extending perpendicular to the stacking direction Z1 of the flexible stack 10. The spatial plane, in which the lateral surface 35 of the further stack 30 extends, is further inclined to the stacking direction Z1 of the flexible stack 10 and may also be inclined to the stacking direction of another further stack.

**Fig. 13** shows in a plan view (i.e., in view from the top) a schematic illustration of a possible arrangement of a further stack 30 relatively to a flexible stack 10, wherein the further stack 30 is rotated by a defined angle about its stacking direction Z3, which is extending perpendicular to the drawing plane, wherein the spatial plane in which the left lateral surface 35 of the further stack 30 extends, and the spatial plane in which the lateral surface 15 of the flexible stack 10 extends, intersect along a virtual line 106 which extends in parallel to the stacking direction Z1 of the flexible stack 10 and also a in parallel to the stacking direction Z3 of the further stack 30.

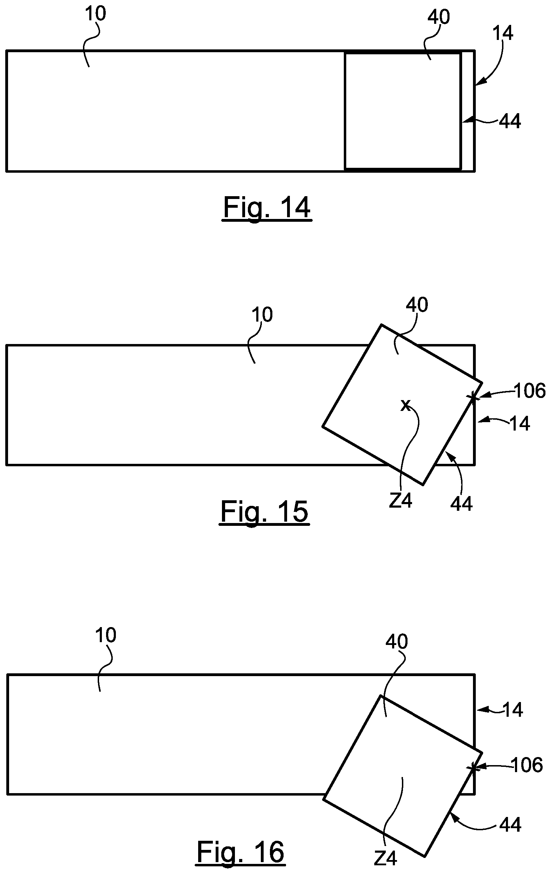

**Figs. 14** to **16** show further possible arrangements of a further stack 40 relatively to a flexible stack 10.

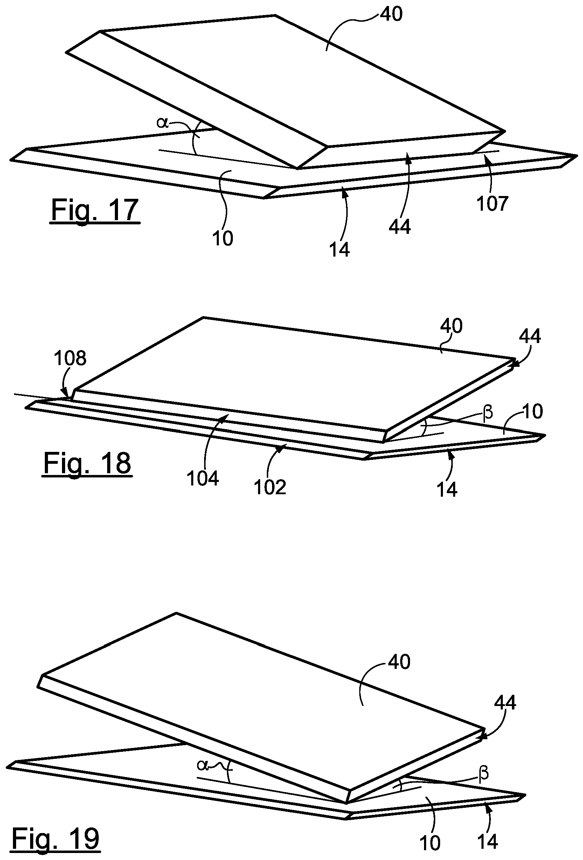

**Figs. 17** to **19** show three-dimensional schematic illustrations of different possible arrangements of a further stack 40 relatively to the flexible stack 10. The further stack 40 may also be arranged inclined by two different angles α and β about one or more axis.

Further, a lateral surface, for example the lateral surface 14, of the flexible stack 10 and/or the corresponding lateral surface of a further stack may extend in a spatial plane, which is inclined to the stacking direction of the respective stack, as it is for example shown in Figs. 17 to 19, in which the lateral surface 14 is inclined to the right and therewith not extending in parallel to stacking direction Z1 of the flexible stack 10. That means in other words, the lateral surface 14 is inclined and not aligned perpendicular to a main surface of the corresponding stack 40. In at least one embodiment, at least one stack, for example stack 40 as shown in Fig. 18, may comprise a parallelogram shape or a parallelogram-like shape, or m comprise a regular or irregular trapezoidal shape.

**Fig. 20** shows in a frontal view (i.e., in a side view from the front) a cross-section of a further embodiment of a component carrier 800 according to the present invention, wherein the component carrier 800 comprises the same basis as the component carrier 400 shown in Fig. 4. However, the component carrier 800 differs from the component carrier 400 from Fig. 4 therein that sub-assembly 92 is arranged on top of sub-assembly 93 thereby overlapping further stack 81 of subassembly 93. The sub-assembly 92, in particular the planar portion 19 of the flexible stack 10, is further electrically connected to stack 81 of the sub-assembly 93 via electrical connections comprising electrically conductive paste. Said planar portion 19 is in particular located adjacent to a stretched-bended portion 17 of the flexible stack 10.

On the opposite side of the flexible stack 10, in particular on the opposite side of the planar portion 19 of the flexible stack 10 facing away from subassembly 93, a further stack 82 is provided on the upper side of the planar portion 19.

In general, in particular in a different embodiment, sub-assembly 92 could also be electrically connected to sub-assembly 93 through a further electrically insulating layer structure being sandwiched between flexible stack 10 and stack 81, wherein one or more electrical connections are extending through said further insulating layer structure. In this case, sub-assemblies 90 and 92 would be directly connected by the flexible stack 10 and also indirectly via stacks/sub-assemblies 93, 60, 70 and 91.

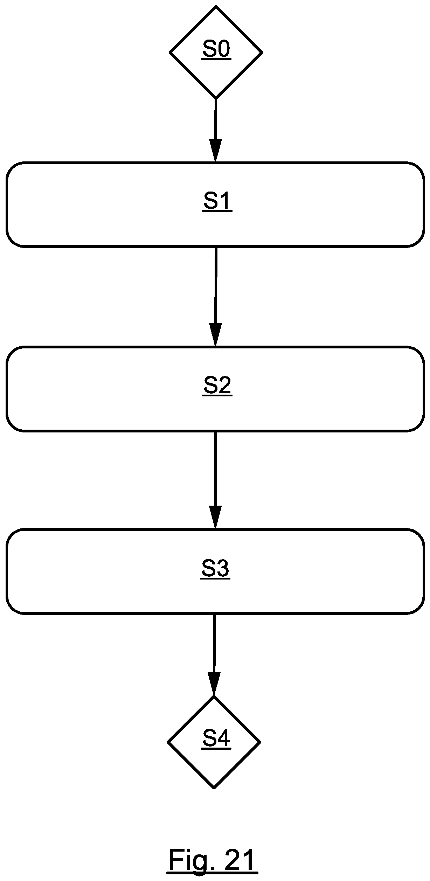

**Fig. 21** shows a flow chart of an embodiment of a method according to the present invention, wherein the method is exemplarily described with respect to the component carrier 100 shown in Fig 1. After a start S0, in a first step S1 a first flexible stack 10 is provided comprising at least one electrically insulating layer structure 11 and at least one electrically conductive layer structure 12. Additionally, in a further step S2, at least two further stacks 20, 30 and 40 are provided, each also comprising at least one electrically insulating layer structure 31, 41 and at least one electrically conductive layer structure 22, 32, 42.

In a third step S3, the at least two further stacks 20, 30 and 40 are electrically connected to the flexible stack 10 by establishing an electrical connection comprising electrically conductive paste, in particular by providing the electrical connections 23, 33 and 43 such that each of the further stacks 20, 30 and 40 is finally electrically connected to the flexible stack 10.

Therein, each of said stacks 10, 20, 30 and 40 comprises a stacking direction and at least one lateral surface 14, 24, 34, 44 respectively 15, 25, 35, 45 limiting the extension of said stack in planar direction perpendicular to its stacking direction Z1, Z2, Z3, Z4.

The flexible stack 10 and the further stacks 20, 30 and 40 are arranged based on the orientation of their lateral surfaces 14, 24, 34, 44 respectively 15, 25, 35, 45 relatively to each other such that the lateral surface 14 of the flexible stack 10, and the lateral surfaces 24, 34, 44 of one of the further stacks 20, 30 and 40, each facing towards a same lateral side of the component carrier 100, are extending in different spatial planes. Further, the spatial planes of the lateral surfaces 15 and 45 are extending in different spatial planes.

Are all electrical connections established, the method may be finished in step S4.

### LIST OF REFERENCE SIGNS

- 100, 200, 300: component carrier
- 400, 500, 600, 700, 800 10, 60: flexible stack
- 11: electrically insulating layer structure of the flexible stack
- 12: electrically conductive layer structure of the flexible stack
- 14, 15, 64, 65: lateral surface of the flexible stack
- 16: interconnection in stacking direction (ZiC)
- 17, 67: bendable region/portion of the flexible stack
- 18, 19; 68, 69: planar portion of the flexible stack
- 20, 30, 40: further stack
- 21, 31, 41, 51: electrically insulating layer structure of a further stack
- 22, 32, 42: electrically conductive layer structure of a further stack
- 23, 33, 43, 53: electrical connection comprising conductive paste
- 24, 34, 44: lateral surface of the further stack
- 25, 35, 45 50, 80, 81, 82, 83, 86, 87: additional stack
- 52: electrically conductive layer structure of the additional stack
- 54, 55; 84, 85: lateral surface of the additional stack
- 70: common further stack
- 90, 91, 92, 93: sub-assembly
- 94, 95 96: component (heat sink)
- 97: component (SMT component or connector)
- 98: component (SMT connector)
- 99: component (press-fit connector)
- 101: component (SMT connector)
- 102: frontal surface of the flexible stack
- 103: rear surface of the flexible stack
- 104: frontal surface of the further stack
- 105: rear surface of the further stack
- 106: virtual intersection line of spatial planes extending in parallel to at least one stacking direction
- 107: (virtual) intersection line of spatial planes on the lateral side extending perpendicular to at least one stacking direction
- 108: (virtual) intersection line of spatial planes on the frontal side extending perpendicular to at least one stacking direction
- 109: space between stacks
- α, β: inclination angle
- B: distance between two planar portions
- d: distance between spatial planes in planar direction
- D1: first distance (from closest electrical connection to edge)
- D2: second distance (from remotest electrical connection to opposite edge)
- P: planar direction (extending perpendicular to stacking direction)
- S0... S4: method steps of an embodiment of a method according to the present invention
- W: width of a further or additional stack
- Z1: stacking direction of the flexible stack
- Z2... Z5: stacking direction of the further stack

## Claims

1. A component carrier (100, 200, 300, 400, 500, 600, 700, 800), comprising:
a flexible stack (10, 60) comprising at least one electrically insulating layer structure (11) and at least one electrically conductive layer structure (12); and
at least two further stacks (20, 30, 40), namely at least a first further stack (30) and a second further stack (40), each also comprising at least one electrically insulating layer structure (31, 41) and at least one electrically conductive layer structure (32, 42);
wherein each of the first further stack (30) and the second further stack (40) is electrically connected to the flexible stack (10, 60) by an electrical connection (33, 43) comprising electrically conductive paste,
wherein each of said stacks (10, 20, 30, 40) comprises a stacking direction (Z1, Z2, Z3, Z4) and at least one lateral surface (14, 15; 64, 65; 24, 25; 34, 35; 44, 45) limiting the extension of said stack (10, 20, 30, 40) in planar direction (P) perpendicular to its stacking direction (Z1, Z2, Z3, Z4),
wherein at least one lateral surface (14, 15; 64, 65) of the flexible stack (10, 60) and at least one lateral surface (34, 35; 44, 45) of one of the at least two further stacks (30, 40), each facing towards a same lateral side of the component carrier (100, 200, 300, 400, 500, 600, 700, 800), are extending in different spatial planes.

2. The component carrier (100, 200, 300, 400, 500, 600, 700, 800) according to claim 1, wherein the at least one lateral surface (14, 15; 64, 65) of the flexible stack (10, 60) is extending in a first spatial plane and the at least one lateral surface (34, 35; 44, 45) of one of the at least two further stacks (30, 40) is extending in a second spatial plane, wherein the first spatial plane and the second spatial plane are extending parallel one to each other, however with a distance (d) in between in a direction perpendicular to the respective spatial planes.

3. The component carrier (100, 200, 300, 400, 500, 600, 700, 800) according to claim 1 or 2, wherein the first spatial plane and the second spatial plane are inclined one to each other.

4. The component carrier (100, 200, 300, 400, 500, 600, 700, 800) according to any one of the preceding claims, wherein at an opposite lateral side of the lateral surface (15, 64) of the flexible stack (10, 60), the flexible stack (10, 60) extends beyond at least one of the further stacks (20, 30, 40) in lateral direction.

5. The component carrier (100, 200, 300, 400, 500, 600, 700, 800) according to claim 12, wherein at least one of the two further stacks (20, 30, 40) is electrically connected to the flexible stack (10, 60) by several electrical connections (23, 33, 43, 53) comprising conductive paste,
wherein the electrical connection of said electrical connections (23, 33, 43, 53) in proximity of an edge, at which the flexible stack (10, 60) extends laterally beyond said at least further stack (20, 30, 40), is distanced from that edge with a first distance (D1),
wherein the electrical connection of said electrical connections (23, 33, 43, 53) in proximity of an edge associated to a lateral side of the at least further stack (20, 30, 40) is distanced from that lateral side with a second distance (D2),
wherein said first distance (D1) is in particular greater than said second distance (D2), in particular at least two times.

6. The component carrier (100, 200, 300, 400, 500, 600, 700, 800) according to any one of the preceding claims, wherein at least one of the electrical connections (23, 33, 43, 53), in particular at least one of the electrical connections (23, 33, 43, 53) by which at least one further stack (20, 30, 40) is electrically connected to the flexible stack (10, 60), in particular at least one of the electrical connections (23, 33, 43, 53) comprising an electrically conductive paste, comprises a cross-section with a diameter varying along the stacking direction of the respective further stack (20, 30, 40), wherein the cross-section diameter in particular increases in direction towards the flexible stack (10, 60), wherein in particular at least one of the electrical connections being arranged adjacent, neighboring or near to an edge, at which the flexible stack (10, 60) extends laterally beyond said at least further stack (20, 30, 40), in particular if the flexible stack (10, 60) comprises at least one bendable region (17, 67) near, adjacent or neighboring to said edge, comprises a cross-section with a diameter varying along the stacking direction (Z2, Z3, Z4) of the respective further stack (20, 30, 40), wherein the cross-section diameter in particular increases in direction towards the flexible stack (10, 60).

7. The component carrier (100, 200, 300, 400, 500, 600, 700, 800) according to any one of the preceding claims, wherein at least one further stack (20, 30, 40) is, in particular all further stacks are, a rigid stack (20, 30, 40).

8. The component carrier (100, 200, 300, 400, 500, 600, 700, 800) according to any one of the preceding claims, wherein the flexible stack (10, 60) comprises at least two planar portions (18, 19; 68, 69), wherein on each one of said at least two planar portions (18, 19; 68, 69) at least one of the two further stacks (20, 30, 40) is arranged.

9. The component carrier (100, 200, 300, 400, 500, 600, 700, 800) according to any one of the preceding claims, wherein the component carrier (100, 200, 300, 400, 500, 600, 700, 800) comprises at least one additional stack (50, 80, 81, 82, 83, 86, 87), wherein in particular the additional stack (50, 80, 81, 82, 83, 86, 87) is arranged on the same side as one of the two further stacks (20, 30, 40) or on the opposite side as one of the two further stacks (20, 30, 40) of the flexible stack (10, 60), wherein the at least one additional stack (50, 80, 81, 82, 83, 86, 87) is in particular arranged on the flexible stack (10, 60) or on at least one of the further stacks (20, 30, 40).

10. The component carrier (100, 200, 300, 400, 500, 600, 700, 800) according to any one of the preceding claims, wherein the flexible stack (10, 60) comprises at least one bendable portion (17, 67), in particular a plurality of bendable portions (17, 67), in particular wherein at least one bendable portion (17, 67) is arranged between at least two planar portions (18, 19; 68, 69) of the flexible stack (10, 60) in lateral direction of said flexible stack (10, 60).

11. The component carrier (100, 200, 300, 400, 500, 600, 700, 800) according to any one of the preceding claims, wherein a distance (B) between two neighboring planar portions in lateral direction is less than the width (W) of at least one further stack (20, 30, 40).

12. The component carrier (100, 200, 300, 400, 500, 600, 700, 800) according to any one of the preceding claims, wherein at least between two neighboring planar portions, wherein on each one a further stack (20, 30, 40) is arranged, at least one element or component, in particular a functional component (96, 97, 98, 99, 101) is in particular electrically connected to at least one of the stacks (10, 20, 30, 40, 50, 60, 70, 80, 81, 82, 83, 86, 87), is arranged.

13. The component carrier (100, 200, 300, 400, 500, 600, 700, 800) according to any one of the preceding claims, wherein the component carrier (100, 200, 300, 400, 500, 600, 700, 800) comprises several sub-assemblies (90, 91, 92, 93, 94, 95), each sub-assembly (90, 91, 92, 93, 94, 95) in particular comprising at least two stacks (80, 30; 20, 70, 50; 81, 40; 83, 82; 86, 87), in particular one flexible stack (10, 60) and/or at least a portion (18, 19; 68, 69) thereof and at least one further stack (20, 30, 40), wherein the flexible stack (10, 60) or the portion thereof is being electrically connected to the at least one further stack (20, 30, 40), wherein the component carrier (100, 200, 300, 400, 500, 600, 700, 800) in particular comprises a common further stack (70), wherein said sub-assemblies (90, 91, 92, 93, 94, 95) are electrically connected to said common further stack (70), wherein said common further stack (70) is in particular electrically connected to and/or includes the first further stack (30) and/or the second further stack (40).

14. A method for manufacturing a component carrier (100, 200, 300, 400, 500, 600, 700, 800) according to any one of the claims 1 to 40, comprising at least the following steps:
- providing a flexible stack (10, 60) comprising at least one electrically insulating layer structure (11) and at least one electrically conductive layer structure (12),
- providing at least two further stacks (20, 30, 40), namely at least a first further stack (30) and a second further stack (40), each also comprising at least one electrically insulating layer structure (31, 41) and at least one electrically conductive layer structure (32, 42), and
- electrically connecting said at least two further stacks (30, 40) by establishing an electrical connection (33, 43) comprising electrically conductive paste such that each of the first further stack (30) and the second further stack (40) is finally electrically connected to the flexible stack (10, 60),
wherein each of said stacks (10, 20, 30, 40) comprises a stacking direction (Z1, Z2, Z3, Z4) and at least one lateral surface (14, 15; 64, 65; 24, 25; 34, 35; 44, 45) limiting the extension of said stack (10, 20, 30, 40) in planar direction (P) perpendicular to its stacking direction (Z1, Z2, Z3, Z4);
wherein the flexible stack (10, 60) and the at least two further stacks(30, 40) are arranged based on the orientation of their lateral surfaces (14, 15; 64, 65; 24, 25; 34, 35; 44, 45) relatively to each other such that at least one lateral surface (14, 15; 64, 65) of the flexible stack and at least one lateral surface (24, 25; 34, 35; 44, 45) of one of the at least two further stacks, each facing towards a same lateral side of the component carrier (100, 200, 300, 400, 500, 600, 700, 800), are extending in different spatial planes.

15. A component carrier assembly comprising a component carrier (100, 200, 300, 400, 500, 600, 700, 800) according to any one of the claims 1 to 40 and/or manufactured according to a method according to claim 41, and at least one further part.
